# EUROPEAN PATENT APPLICATION

(11) **EP 4 648 591 A1**
(43) Date of publication of application: **12.11.2025**
(21) Application number: 23953681.6
(22) Date of filing: 28.09.2023
(51) Int. Cl.: H10K 59/131, H10K 59/12

(54) **DISPLAY PANEL AND DISPLAY DEVICE**

(71) Applicant: Boe Technology Group Co., Ltd., Beijing 100015 (CN); Chengdu BOE Optoelectronics Technology Co., Ltd., Chengdu, Sichuan 611731 (CN)
(72) Inventor: ZHANG, Yuanqi, Beijing 100176 (CN); ZHANG, Yi, Beijing 100176 (CN); MA, Hongwei, Beijing 100176 (CN); LAN, Daijiang, Beijing 100176 (CN)
(74) Representative: Brötz, Helmut
(86) International application number: PCT/CN2023/122646
(87) International publication number: WO 2025/065532

(57) **Abstract**

A display panel and a display device. The display panel comprises a substrate, a touch signal line, and a shading structure. The substrate comprises an active area and a non-active area at least partially surrounding the active area. The display area comprises display pixels. The touch signal line is located in the non-active area, at least partially surrounds the active area, and is configured to provide a touch signal for the active area. The shading structure is located in the non-active area, at least partially surrounds the active area and is located on the side of the touch signal line away from the active area, and the shading structure comprises a first shading structure and a second shading structure, the first light-shielding structure and the second light-shielding structure being located in different layers, respectively, and orthographic projections, on the substrate, of the first light-shielding structure and the second light-shielding structure adjacent to each other in a direction from the active area to the non-active area do not completely overlap with each other.

## Description

### TECHNICAL FIELD

Embodiments of the present disclosure relate to a display panel and a display device.

### BACKGROUND

A display panel usually includes a display region and a non-display region. The display region is used to display a desired image, while the non-display region is used to arrange circuit structures for controlling the operation of the display region. For example, the circuit structure includes a display driving circuit, various lines, a flexible circuit board, etc. The non-display region may also be provided with various structures to ensure screen encapsulation, such as dam.

In a touch display panel, recognition of a touch position is usually achieved by providing touch electrodes, the touch electrodes need to be connected to a circuit board, the circuit board provides touch signals to the touch electrodes. The touch electrodes may be applied to a flexible display panel, for example, the touch electrodes may be provided between an encapsulation cover plate and light-emitting devices such as organic light-emitting diodes (OLEDs) to form a flexible touch display panel.

### SUMMARY

At least one embodiment of the present disclosure provides a display panel, the display panel includes a substrate, a touch signal line, and a light-shielding structure. The substrate includes a display region and a non-display region at least partially surrounding the display region, the display region includes display pixels; the touch signal line is in the non-display region and at least partially surrounds the display region, and is configured to provide a touch signal to the display region; the light-shielding structure is in the non-display region and at least partially surrounds the display region, and is on a side of the touch signal line away from the display region, the light-shielding structure includes a first light-shielding structure and a second light-shielding structure, the first light-shielding structure and the second light-shielding structure are respectively located in different layers, and orthographic projections of the first light-shielding structure and the second light-shielding structure that are adjacent to each other in a direction from the display region to the non-display region on the substrate are not completely overlapped.

For example, in the display panel provided by at least an embodiment of the present disclosure, the light-shielding structure comprises a plurality of first light-shielding structures, the plurality of first light-shielding structures are arranged in a direction from the display region to the non-display region, an interval is provided between the plurality of first light-shielding structures, and an orthographic projection of the second light-shielding structure on the substrate at least partially overlaps with an orthographic projection of the interval between the plurality of first light-shielding structures on the substrate.

For example, the display panel provided by at least an embodiment of the present disclosure further comprises a light-shielding layer, the light-shielding layer is in the non-display region and at least partially surrounds the display region; the touch signal line is on a side of the light-shielding layer close to the display region, and the light-shielding structure is between the light-shielding layer and the touch signal line; an orthographic projection of at least part of the light-shielding structure on the substrate overlaps with an orthographic projection of an edge of the light-shielding layer close to the display region on the substrate.

For example, in the display panel provided by at least an embodiment of the present disclosure, the touch signal line comprises a first portion extending along a first direction, an arrangement direction of the touch signal line and the light-shielding structure is a second direction, and the first direction intersects with the second direction; the display panel further comprises a main grounding line, the main grounding line is on a side of the touch signal line away from the display region, and comprising a first portion surrounding the display region and extending along the first direction; at least part of the first light-shielding structure and at least part of the second light-shielding structure are on a side of the first portion of the main grounding line away from the display region; the first light-shielding structure and the second light-shielding structure are grounded as auxiliary grounding lines, and the first light-shielding structure and the second light-shielding structure are connected to the main grounding line to be grounded or electrically connected to an integrated circuit board to be grounded, or, the first light-shielding structure and the second light-shielding structure are floating to serve as first floating lines, and the first floating lines transmit no electrical signal.

For example, the display panel provided by at least an embodiment of the present disclosure further comprises a first dam, the first dam is in the non-display region and at least partially surrounds the display region, the touch signal line is on a side of the first dam close to the display region, the first dam is on a side of the edge of the light-shielding layer close to the display region, and on a side of the first portion of the main grounding line away from the display region; the light-shielding structure comprises a plurality of the first light-shielding structures and a plurality of the second light-shielding structures, wherein the plurality of first light-shielding structures and the plurality of second light-shielding structures are respectively spaced apart from each other from the display region to the non-display region; the plurality of first light-shielding structures comprise a first part of first light-shielding structures and a second part of first light-shielding structures, and the plurality of second light-shielding structures comprise a first part of second light-shielding structures and a second part of second light-shielding structures; the first part of first light-shielding structures and the first part of second light-shielding structures are on a side of the first dam close to the display region, and the second part of first light-shielding structures and the second part of second light-shielding structures are on a side of the first dam away from the display region; an orthographic projection of at least one selected from a group consisting of the plurality of first light-shielding structures and the plurality of second light-shielding structures on the substrate at least partially overlaps with an orthographic projection of the first dam on the substrate.

For example, in the display panel provided by at least an embodiment of the present disclosure, the substrate has a main surface, and the touch signal line, the light-shielding structure, and the first dam are on the main surface of the substrate, in a direction perpendicular to the main surface of the substrate, the first light-shielding structure is between the second light-shielding structure and the first dam; the first dam has an upper surface away from the substrate and a side surface intersecting with the upper surface of the first dam; in the direction perpendicular to the main surface of the substrate, the first light-shielding structure at least partially overlaps with the upper surface of the first dam, and the second light-shielding structure adjacent to the first light-shielding structure overlaps with the first light-shielding structure and overlaps with the side surface of the first dam.

For example, in the display panel provided by at least an embodiment of the present disclosure, the side surface of the first dam comprises a first side surface on a first side of the first light-shielding structure and a second side surface on a second side of the first light-shielding structure, the first side and the second side of the first light-shielding structure are opposite in the direction from the display region to the non-display region; in the direction perpendicular to the main surface of the substrate, the second light-shielding structure adjacent to the first light-shielding structure on the first side of the first light-shielding structure overlaps with the first light-shielding structure and overlaps with the first side surface of the first dam, and the second light-shielding structure adjacent to the first light-shielding structure on the second side of the first light-shielding structure overlaps with the first light-shielding structure and overlaps with the second side surface of the first dam.

For example, in the display panel provided by at least an embodiment of the present disclosure, the display panel further comprises a second dam, the second dam is spaced apart from the first dam and is on a side of the first dam away from the display region, a portion of the plurality of first light-shielding structures and a portion of the plurality of second light-shielding structures are between the second dam and the first dam, and another portion of the plurality of first light-shielding structures and another portion of the plurality of second light-shielding structures overlap with the second dam in the direction perpendicular to the main surface of the substrate.

For example, the display panel provided by at least an embodiment of the present disclosure further comprises an encapsulation layer; the light-shielding layer is on an outer surface of the encapsulation layer away from the substrate; a material of the light-shielding layer is an opaque organic material, and the opaque organic material comprises ink.

For example, in the display panel provided by at least an embodiment of the present disclosure, a width, in a direction from the display region to the non-display region, of an overlapping portion of orthographic projections of the first light-shielding structure and the second light-shielding structure that are adjacent to each other in the direction from the display region to the non-display region on the substrate is greater than 1µm.

For example, in the display panel provided by at least an embodiment of the present disclosure, between the edge of the light shielding layer and the main grounding line, the interval between adjacent first light-shielding structures is in a range of 8µm ~ 20µm, and the interval between adjacent second light-shielding structures is in a range of 8µm ~ 20µm; the line width of each first light-shielding structure in the direction from the display region to the non-display region is in a range of 8µm ~ 20µm, and the line width of each second light-shielding structure in the direction from the display region to the non-display region is in a range of 8µm ~ 20µm.

For example, in the display panel provided by at least an embodiment of the present disclosure, at least one of two structures consisting of the first light-shielding structure and the second light-shielding structure on a side of the first portion of the main grounding line away from the display region comprises an integral piece of light-shielding structure, and a width of the integral piece of light-shielding structure in a direction from the display region to the non-display region is greater than half of a distance between an edge of the first portion of the main grounding line away from the display region and an edge of the light-shielding layer close to the display region.

For example, the display panel provided by at least an embodiment of the present disclosure further comprises a protection line, the protection line extends along the first direction and is between the touch signal line and the main grounding line; a waveform of an electrical signal transmitted by the protection line is substantially same as a waveform of an electrical signal transmitted by the touch signal line, and the protection line comprises a first portion surrounding the display region; the width of the integral piece of light-shielding structure in the direction from the display region to the non-display region is greater than a distance between an edge of the first portion of the protection line away from the display region and the edge of the first portion of the main grounding line close to the display region.

For example, in the display panel provided by at least an embodiment of the present disclosure, the substrate has a main surface, and the touch signal line and the light-shielding structure are on the main surface of the substrate, the integral piece of light-shielding structure is an integral structure, and the integral piece of light-shielding structure is provided with a plurality of holes penetrating the integral piece of light-shielding structure in a direction perpendicular to the main surface of the substrate.

For example, in the display panel provided by at least an embodiment of the present disclosure, an area of the integral piece of light-shielding structure is greater than 0.25 mm².

For example, in the display panel provided by at least an embodiment of the present disclosure, the integral piece of light-shielding structure comprises a plurality of sub-portions spaced apart from each other, and at least one of the sub-portions is provided with a plurality of holes penetrating the at least one of the sub-portions in the direction perpendicular to the main surface of the substrate; or, at least one of the sub-portions is provided with no hole.

For example, in the display panel provided by at least an embodiment of the present disclosure, an area of the at least one of the sub-portions provided with the plurality of holes is greater than 0.25 mm², and an area of the at least one of the sub-portions provided with no hole is less than or equal to 0.25 mm².

For example, in the display panel provided by at least an embodiment of the present disclosure, an area of the plurality of holes in the integral piece of light-shielding structure accounts for 20% to 60% of an area of the integral piece of light-shielding structure.

For example, in the display panel provided by at least an embodiment of the present disclosure, the display panel further comprises a detection line, the detection line is in the non-display region and surrounding the display region, a first end and a second end of the detection line are electrically connected to an integrated circuit board to receive a detection signal, the detection line comprises a first portion surrounding the display region and extending along the first direction, and the first portion of the detection line is on a side of the first portion of the main grounding line away from the display region; the light-shielding structure comprises a portion on a side of the first portion of the detection line close to the display region; and/or, the light-shielding structure comprises a portion on a side of the first portion of the detection line away from the display region.

For example, in the display panel provided by at least an embodiment of the present disclosure, the first light-shielding structure and the second light-shielding structure extend in a same direction as the touch signal line and are substantially parallel to the touch signal line.

For example, the display panel provided by at least an embodiment of the present disclosure further comprises a protection line, the protection line is arranged along the touch signal line and between the touch signal line and the main grounding line, a waveform of an electrical signal transmitted by the protection line is substantially same as a waveform of an electrical signal transmitted by the touch signal line, and the protection line comprises a first portion surrounding the display region; the light-shielding structure further comprises a second floating line, the second floating line is between the first portion of the protection line and the first portion of the main grounding line, and the second floating line transmit no electrical signal.

For example, in the display panel provided by at least an embodiment of the present disclosure, the touch signal line comprises a first portion extending along the first direction, an arrangement direction of the touch signal line and the light-shielding structure is a second direction, and the first direction intersects with the second direction; the display panel further comprises a protection line, the protection line is arranged along the touch signal line and between the touch signal line and the main grounding line, a waveform of an electrical signal transmitted by the protection line is substantially same as a waveform of an electrical signal transmitted by the touch signal line, and the protection line comprises a first portion surrounding the display region and extending along the first direction; the light-shielding structure further comprises a third floating line, the third floating line is between the first portion of the protection line and the touch signal line, and the third floating line transmits no electrical signal.

For example, the display panel provided by at least an embodiment of the present disclosure further comprises a first touch electrode, a second touch electrode and a bridge electrode. The first touch electrode is in the display region and comprises a plurality of first touch electrode channels spaced apart from each other, the plurality of touch signal lines are connected in one-to-one correspondence with the plurality of first touch electrode channels and are configured to provide touch signals to corresponding first touch electrode channels, and each of the first touch electrode channels comprises a plurality of first sub touch electrodes spaced apart from each other; the second touch electrode is in the display region and comprises a plurality of second touch electrode channels spaced apart from each other, an extension direction of the plurality of second touch electrode channels intersects with an extension direction of the plurality of first touch electrode channels; the plurality of second touch electrode channels and the plurality of first sub touch electrodes are arranged in a same layer and are insulated from each other, each of the second touch electrode channels comprises a plurality of second sub touch electrodes spaced apart from each other; the bridge electrode is arranged in a different layer from the plurality of second sub touch electrodes and the plurality of first sub touch electrodes, and electrically connected to two adjacent first sub touch electrodes of the plurality of first sub touch electrodes in a same first sub touch electrode channel, and insulated from the second touch electrode; the first light-shielding structure, the first sub touch electrode and the second sub touch electrode are in a same layer and made of a same material, and the second light-shielding structure and the bridge electrode are in a same layer and made of a same material.

For example, in the display panel provided by at least an embodiment of the present disclosure, the light-shielding structure comprises a plurality of the first light-shielding structures and a plurality of the second light-shielding structures, each of the first light-shielding structures and each of the second light-shielding structures at least partially extend along the first direction, the second direction intersects with the first direction; the plurality of first light-shielding structures are in a first light-shielding layer, and plurality of second light-shielding structures are in a second light-shielding layer; in the first light-shielding layer, a portion, extending along the first direction, of at least part of the plurality of first light-shielding structures is disconnected by at least one first opening, and each first light-shielding structure of the at least part of the plurality of first light-shielding structures that is disconnected by the first opening comprises two portions spaced apart by the first opening in the first direction; in the second light-shielding layer, a portion, extending along the first direction, of at least part of the plurality of second light-shielding structures is disconnected by at least one second opening, and each second light-shielding structure of the at least part of the plurality of second light-shielding structures that is disconnected by the second opening comprises two portions spaced apart by the second opening in the first direction.

For example, in the display panel provided by at least an embodiment of the present disclosure, a pattern formed by an interconnection of orthographic projections of the at least one first opening and the at least one second opening on the main surface of the substrate as a whole is in a strip shape extending along a third direction, and the third direction intersects with both the first direction and the second direction.

For example, in the display panel provided by at least an embodiment of the present disclosure, the light-shielding structure comprises a plurality of the first light-shielding structures and a plurality of the second light-shielding structures, each of the first light-shielding structures and each of the second light-shielding structures at least partially extend along a first direction; the display panel comprises a main grounding line, the main grounding line is on a side of the touch signal line away from the display region, and comprises a first portion surrounding the display region and extending along an extension direction of the touch signal line, and comprises a second portion connected to the first portion of the main grounding line, an extension direction of the second portion of the main grounding line intersects with the extension direction of the first portion of the main grounding line; the display panel further comprises a first auxiliary connection portion, at least part of the first light-shielding structures among the plurality of first light-shielding structures is directly connected to the second portion of the grounding line, the first auxiliary connection portion and the plurality of first light-shielding structures are in a same layer, and the first auxiliary connection portion crosses an interval between two adjacent first light-shielding structures to connect the two adjacent first light-shielding structures; the display panel further comprises a second auxiliary connection portion, at least part of the second light-shielding structures among the plurality of second light-shielding structures is directly connected to the second portion of the grounding line, the second auxiliary connection portion and the plurality of second light-shielding structures are in a same layer, and the second auxiliary connection portion crosses an interval between two adjacent second light-shielding structures to connect the two adjacent second light-shielding structures.

For example, the display panel provided by at least an embodiment of the present disclosure further comprises a pixel driving circuit layer in the non-display region; the pixel driving circuit layer comprises a plurality of signal lines, the plurality of signal lines comprise a signal line in the display region and a signal line in the non-display region, an orthographic projection of the signal line in the non-display region on the main surface of the substrate overlaps with an orthographic projection of the light-shielding structure on the main surface of the substrate.

At least one embodiment of the present disclosure provides a display panel, the display panel includes a substrate, a touch signal line, a light-shielding structure, and a light-shielding layer. The substrate includes a display region and a non-display region at least partially surrounding the display region, the display region includes display pixels; the touch signal line is in the non-display region and at least partially surrounds the display region, and is configured to provide a touch signal to the display region; the light-shielding structure is in the non-display region and on a side of the touch signal line away from the display region, the light-shielding layer is in the non-display region and at least partially surrounds the display region, the touch signal line is on a side of the light-shielding layer close to the display region, and the light-shielding structure is between the light-shielding layer and the touch signal line; the touch signal line comprises a first portion extending along a first direction, an arrangement direction of the touch signal line and the light-shielding structure is a second direction, and the first direction intersects with the second direction; the light-shielding structure includes an integral piece of light-shielding structure, a width of the integral piece of light-shielding structure in a direction from the display region to the non-display region is greater than half of a distance between an edge of the first portion of the touch signal line away from the display region and an edge of the light-shielding layer close to the display region.

For example, the display panel provided by at least an embodiment of the present disclosure further comprises a main grounding line, the main grounding line is on a side of the touch signal line away from the display region, and comprises a first portion surrounding the display region and extending along the first direction, and the integral piece of light-shielding structure is on a side of the first portion of the main grounding line away from the display region; the integral piece of light-shielding structure is grounded as an auxiliary grounding line, and is connected to the main grounding line to be grounded or electrically connected to an integrated circuit board to be grounded.

For example, the display panel provided by at least an embodiment of the present disclosure further comprises a protection line, the protection line extends along the first direction and between the touch signal line and the main grounding line; a waveform of an electrical signal transmitted by the protection line is substantially same as a waveform of an electrical signal transmitted by the touch signal line, and the protection line comprises a first portion surrounding the display region; a width of the integral piece of light-shielding structure in a direction from the display region to the non-display region is greater than a distance between an edge of the first portion of the protection line away from the display region and an edge of the first portion of the main grounding line close to the display region.

For example, in the display panel provided by at least an embodiment of the present disclosure, the substrate has a main surface, and the touch signal line and the light-shielding structure are on the main surface of the substrate, the integral piece of light-shielding structure is an integral structure, and the integral piece of light-shielding structure is provided with a plurality of holes penetrating the integral piece of light-shielding structure in a direction perpendicular to the main surface of the substrate.

For example, in the display panel provided by at least an embodiment of the present disclosure, an area of the integral piece of light-shielding structure is greater than 0.25 mm².

For example, in the display panel provided by at least an embodiment of the present disclosure, the substrate has a main surface, and the touch signal line and the light-shielding structure are on the main surface of the substrate; the integral piece of light-shielding structure comprises a plurality of sub-portions spaced apart from each other, and at least one of the sub-portions is provided with a plurality of holes penetrating the at least one of the sub-portions in a direction perpendicular to the main surface of the substrate; or, at least one of the sub-portions is provided with no hole.

For example, in the display panel provided by at least an embodiment of the present disclosure, an area of the at least one of the sub-portions provided with the plurality of holes is greater than 0.25 mm², and an area of the at least one of the sub-portions provided with no hole is less than or equal to 0.25 mm².

For example, in the display panel provided by at least an embodiment of the present disclosure, an area of the plurality of holes in the integral piece of light-shielding structure accounts for 20% to 60% of an area of the integral piece of light-shielding structure.

For example, in the display panel provided by at least an embodiment of the present disclosure, the substrate has a main surface, and the touch signal line and the light-shielding structure are on the main surface of the substrate, an edge, away from the display region, of an orthographic projection of the light-shielding structure on the main surface of the substrate overlaps with an orthographic projection of the light-shielding layer on the main surface of the substrate.

For example, the display panel provided by at least an embodiment of the present disclosure further comprises a first touch electrode, a second touch electrode and a bridge electrode. The first touch electrode is in the display region and comprises a plurality of first touch electrode channels spaced apart from each other, the plurality of touch signal lines are connected in one-to-one correspondence with the plurality of first touch electrode channels and are configured to provide touch signals to corresponding first touch electrode channels, and each of the first touch electrode channels comprises a plurality of first sub touch electrodes spaced apart from each other; a second touch electrode, in the display region and comprising a plurality of second touch electrode channels spaced apart from each other, an extension direction of the plurality of second touch electrode channels intersects with an extension direction of the plurality of first touch electrode channels; the plurality of second touch electrode channels and the plurality of first sub touch electrodes are arranged in a same layer and are insulated from each other, each of the second touch electrode channels comprises a plurality of second sub touch electrodes spaced apart from each other; the bridge electrode is arranged in a different layer from the plurality of second sub touch electrodes and the plurality of first sub touch electrodes, and electrically connected to two adjacent first sub touch electrodes of the plurality of first sub touch electrodes in a same first sub touch electrode channel, and insulated from the second touch electrode; the light-shielding structure, the first sub touch electrode and the second sub touch electrode are in a same layer and made of a same material, or the light-shielding structure and the bridge electrode are in a same layer and made of a same material.

At least one embodiment of the present disclosure provides a display device, the display device includes any display panel provided by the embodiments of the present disclosure.

### BRIEF DESCRIPTION OF DRAWINGS

In order to clearly illustrate technical solutions of the embodiments of the present disclosure, the drawings of the embodiments will be briefly described. It is obvious that the described drawings in the following are only related to some embodiments of the present disclosure and thus are not construed as any limitation to the present disclosure.
Fig. 1 is a schematic diagram of a display panel provided by an embodiment of the present disclosure;
Fig. 2 is a schematic diagram of a touch structure of a display panel provided by an embodiment of the present disclosure;
Fig. 3 is a schematic diagram of the display panel shown in Fig. 1 after removing a light-shielding structure in a local portion P1;
Fig. 4 is a schematic diagram of a portion, close to a first edge, of a non-display region shown in Fig. 1 including the local portion P1 of the light-shielding structure;
Fig. 5 is a cross-sectional schematic diagram of a non-display region including a light-shielding structure of a display panel provided by an embodiment of the present disclosure;
Fig. 6 is another schematic diagram of a portion, close to a first edge, of a non-display region shown in Fig. 1 including the local portion P1 of the light-shielding structure;
Fig. 7 is another schematic diagram of a portion, close to a first edge, of a non-display region shown in Fig. 1 including the local portion P1 of the light-shielding structure;
Fig. 8 is another schematic diagram of a portion, close to a first edge, of a non-display region shown in Fig. 1 including the local portion P1 of the light-shielding structure;
Fig. 9 is another schematic diagram of a portion, close to a first edge, of a non-display region shown in Fig. 1 including the local portion P1 of the light-shielding structure;
Fig. 10 is another schematic diagram of a portion, close to a first edge, of a non-display region shown in Fig. 1 including the local portion P1 of the light-shielding structure;
Fig. 11 is another schematic diagram of a portion, close to a first edge, of a non-display region shown in Fig. 1 including the local portion P1 of the light-shielding structure;
Fig. 12 is another schematic diagram of a portion, close to a first edge, of a non-display region shown in Fig. 1 including the local portion P1 of the light-shielding structure; and
Fig. 13 is a schematic diagram of a display device provided by an embodiment of the present disclosure.

### DETAILED DESCRIPTION

In order to make objectives, technical details, and advantages of the embodiments of the present disclosure clearer, the technical solutions of the embodiments will be described in a clearly and fully understandable way in connection with the drawings related to the embodiments of the present disclosure. Apparently, the described embodiments are just a part but not all of the embodiments of the present disclosure. Based on the described embodiments herein, those skilled in the art can obtain other embodiment(s), without any inventive work, which should be within the scope of the present disclosure.

Unless otherwise defined, all the technical and scientific terms used herein have the same meanings as commonly understood by one of ordinary skill in the art to which the present disclosure belongs. The terms "first", "second", etc., which are used in the present disclosure, are not intended to indicate any sequence, amount or importance, but distinguish various components. Also, the terms "comprise," "comprising," "include," "including," etc., are intended to specify that the elements or the objects stated before these terms encompass the elements or the objects and equivalents thereof listed after these terms, but do not preclude the other elements or objects. The phrases "connect", "connected", etc., are not intended to define a physical connection or mechanical connection, but may include an electrical connection, directly or indirectly. "On," "under," "left," "right" and the like are only used to indicate relative position relationship, and when the position of the object which is described is changed, the relative position relationship may be changed accordingly.

Because of the presence of various lines on the display panel, light is reflected and refracted between the layers in the non-display region. Even when the display panel is in a resting state, users can still see the light reflected from the non-display region, resulting in light leakage. To prevent light leakage in the non-display region of the display panel, for example, a light-shielding layer may be provided to the non-display region to block light. However, there are issues about the fitting and manufacturing tolerances of the light-shielding layer, and at the same time, it is necessary to meet the requirements of the entire machine, there should be a certain distance between the edge of the light-shielding layer and the display region. Because of the presence of a light leakage region between the edge of the light-shielding layer close to the display region and the display region and the light leakage region is not shielded by the light-shielding layer, the light in the light leakage region will not be shield, thereby allowing light to pass through the light leakage region.

At least one embodiment of the present disclosure provides a display panel, the display panel includes a substrate, a touch signal line, and a light-shielding structure. The substrate includes a display region and a non-display region at least partially surrounding the display region, the display region includes display pixels; the touch signal line is in the non-display region and at least partially surrounds the display region, and is configured to provide a touch signal to the display region; the light-shielding structure is in the non-display region and at least partially surrounds the display region, and is on a side of the touch signal line away from the display region, the light-shielding structure includes a first light-shielding structure and a second light-shielding structure, the first light-shielding structure and the second light-shielding structure are respectively located in different layers, and orthographic projections of the first light-shielding structure and the second light-shielding structure that are adjacent to each other in a direction from the display region to the non-display region on the substrate are not completely overlapped.

At least one embodiment of the present disclosure provides a display panel, the display panel includes a substrate, a touch signal line, a light-shielding structure, and a light-shielding layer. The substrate includes a display region and a non-display region at least partially surrounding the display region, the display region includes display pixels; the touch signal line is in the non-display region and at least partially surrounds the display region, and is configured to provide a touch signal to the display region; the light-shielding structure is in the non-display region and on a side of the touch signal line away from the display region, the light-shielding layer is in the non-display region and at least partially surrounds the display region, the touch signal line is on a side of the light-shielding layer close to the display region, and the light-shielding structure is between the light-shielding layer and the touch signal line; the touch signal line comprises a first portion extending along a first direction, an arrangement direction of the touch signal line and the light-shielding structure is a second direction, and the first direction intersects with the second direction; the light-shielding structure includes an integral piece of light-shielding structure, a width of the integral piece of light-shielding structure in a direction from the display region to the non-display region is greater than half of a distance between an edge of the first portion of the touch signal line away from the display region and an edge of the light-shielding layer close to the display region.

At least one embodiment of the present disclosure provides a display device, the display device includes any display panel provided by the embodiments of the present disclosure.

The display panel and the display device provided by the embodiments of the present disclosure are illustrated in combination with exemplary drawings. It should be noted that the number of light-shielding structures in the embodiments of the present disclosure, such as the number of the auxiliary grounding line, the first floating line, and the second floating line, is not limited to the number shown in the drawings. Those skilled in the art can design the number according to the size of the light leakage region. The size of each structure in the attached drawings does not represent the actual size, and all the drawings are schematic diagrams.

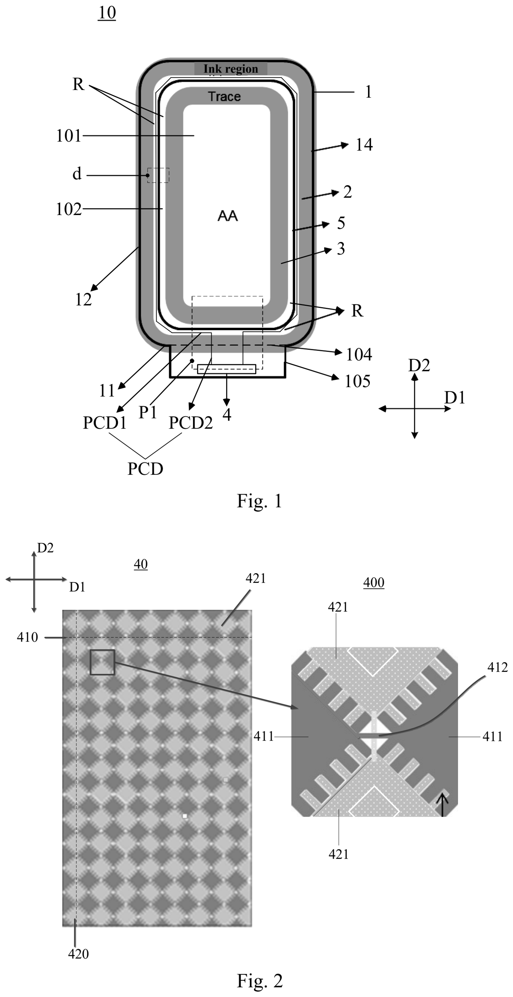

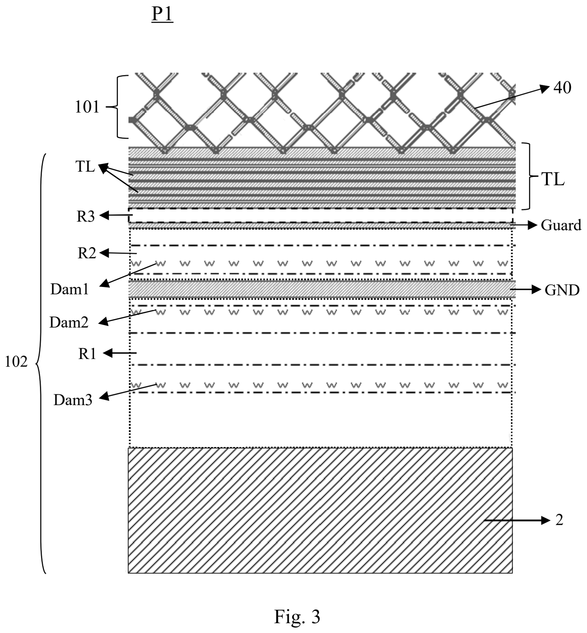

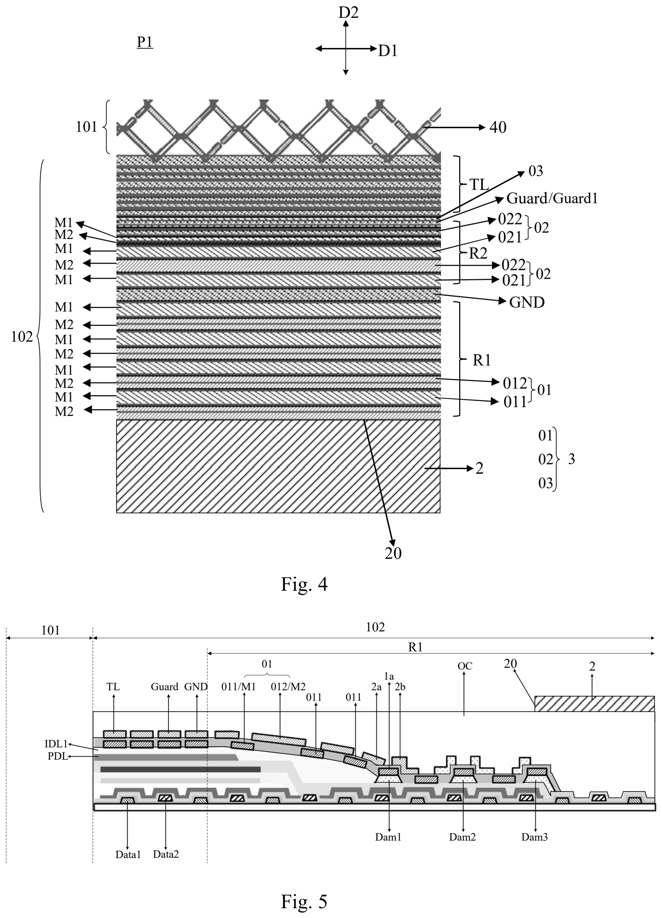

Exemplarily, Fig. 1 is a schematic diagram of a display panel provided by an embodiment of the present disclosure, Fig. 3 is a schematic diagram of the display panel shown in Fig. 1 after removing a light-shielding structure in a local portion P1, and Fig. 4 is a schematic diagram of a portion, close to a first edge, of a non-display region shown in Fig. 1 including the local portion P1 of the light-shielding structure. Referring to Fig. 1, Fig. 3, and Fig. 4, the display panel 10 provided by at least one embodiment of the present disclosure includes a substrate 1, a touch signal line TL, and a light-shielding structure 3. The substrate 1 includes a display region 101 and a non-display region 102 at least partially surrounding the display region 101. The display region 101 includes display pixels, the substrate 1 has a main surface, and the display pixels, the touch signal line TL, the light-shielding structure 3, and the following plurality of dams are located on the main surface of the substrate 1. The touch signal line TL is located in the non-display region 102, at least partially surrounds the display region 101, and is configured to provide a touch signal to the display region 101; the light-shielding structure 3 is located in the non-display region 102, at least partially surrounds the display region 101, and is located on a side of the touch signal line TL away from the display region 101. The light-shielding structure 3 includes a first light-shielding structure 011/021 and a second light-shielding structure 012/022. The first light-shielding structure 011/021 and the second light-shielding structure 012/022 are respectively located in different layers, and orthographic projections of the first light-shielding structure 011/021 and the second light-shielding structure 012/022 that are adjacent to each other in a direction from the display region 101 to the non-display region 102 on the substrate 1 are not completely overlapped. There are various lines, such as a plurality of touch signal lines TL, grounding lines GND, etc., arranged at the position of the non-display region 102 close to the display region 101. However, the plurality of touch signal lines TL are spaced apart from each other, and there are also some intervals between the touch signal lines TL and the grounding lines GND or other lines. Therefore, because of the fitting and manufacturing tolerances of the light-shielding layer in the non-display region 102, and the intervals between the plurality of lines, the light-shielding layer and the plurality of lines in the non-display region 102 cannot fully cover the non-display region 102, which leads to the light leakage in the uncovered region of the non-display region 102, resulting in the light leakage in the non-display region. For example, there is a light leakage phenomenon on the edge of the screen close to the display region. In the embodiments of the present disclosure, the edge light leakage phenomenon of the display panel is reduced by blocking the light leakage region through the light-shielding structure 3. The first light-shielding structure and the second light-shielding structure that are respectively located in different layers are overlapped with each other, thereby increasing the light-shielding area of the light leakage region. For example, the first light-shielding structure and second light-shielding structure that are overlapped with each other can completely cover the light leakage region, thereby achieving better light-shielding effect in the non-display region 102.

Different layers refer to at least two different layers arranged in the direction perpendicular to the main surface of the substrate 1, and the at least two layers need to be obtained by performing different patterning processes on different layers.

Numeral references 011 and 021 respectively represent the first light-shielding structure and the second light-shielding structure located in the first light leakage region R1, while numeral references 021 and 022 respectively represent the first light-shielding structure and the second light-shielding structure located in the second leakage region R2. The following will provide a detailed introduction.

For example, a width, in a direction from the display region 101 to the non-display region 102, of an overlapping portion of orthographic projections of the first light-shielding structure 011/021 and the second light-shielding structure 012/022 that are adjacent to each other in the direction from the display region 101 to the non-display region 102 on the substrate is greater than 1µm, to meet the requirements of the production process while ensuring good light-shielding effect, and to produce products that meet the requirements and ensure the yield of the display panel.

Fig. 2 is a schematic diagram of a touch structure 40 of a display panel 10 provided by an embodiment of the present disclosure. As shown in Fig. 2, for example, the touch electrode structure 40 is located in the display region 101 and includes a first touch electrode and a second touch electrode. The first touch electrode includes a plurality of first touch electrode channels 410 spaced apart from each other (one first touch electrode channel 410 is at the position indicated by the corresponding dashed line in Fig. 2), and the second touch electrode includes a plurality of second touch electrode channels 420 spaced apart from each other (one second touch electrode channel 420 is at the position indicated by the corresponding dashed line in Fig. 2). The extension direction of the plurality of second touch electrode channels 420 intersects with the extension direction of the plurality of first touch electrode channels 410. For example, the plurality of first touch electrode channels 410 extend along the first direction D1, the plurality of second touch electrode channels 420 extend along the second direction D2, and the second direction D2 intersects with the first direction D1. For example, the second direction D2 is perpendicular to the first direction D1, to facilitate the electrical connection with the plurality of touch signal lines TL, and to maintain a regular pattern. Of course, the extension direction of the plurality of second touch electrode channels 420 and the extension direction of the plurality of first touch electrode channels 410 are not limited to this situation. For example, the first touch electrode channel 410 is a touch sensing electrode Rx, and the second touch electrode channel 420 is a touch driving electrode Tx. However, the embodiments of the present disclosure are not limited in this aspect. In other examples, the first touch electrode channel 410 may be the touch driving electrode Tx, while the second touch electrode channel 420 is the touch sensing electrode Rx.

Each first touch electrode channel 410 includes a plurality of first sub touch electrodes 411 spaced apart from each other, and each second touch electrode channel 420 includes a plurality of second sub touch electrodes 421 arranged sequentially along the second direction D2 and connected with each other. For example, the plurality of second sub touch electrodes 421 and the plurality of first sub touch electrodes 411 are arranged in the same layer and insulated from each other. The touch structure further includes a bridge electrode 412, the bridge electrode 412 is arranged in a different layer from the plurality of second sub touch electrodes 421 and the plurality of first sub touch electrodes 411, and is electrically connected to two adjacent first sub touch electrodes 411 in the plurality of first sub touch electrodes 411 of the same first touch electrode channel 410, and is insulated from the second touch electrode channel 420. That is, the adjacent first sub touch electrodes 411 in the first direction D1 is electrically connected through the bridge electrode 412 to form the first touch electrode channel 410, the adjacent second sub touch electrodes 421 in the second direction D2 is electrically connected through a second connection electrode (not shown) to form the second touch electrode channel 420. For example, the touch structure 40 includes a first metal layer and a second metal layer, the plurality of second touch electrode channels 420 and the plurality of first touch electrode channels 410 are located in the first metal layer of the touch structure 40, and the bridge electrode 412 is located in the second metal layer of the touch structure 40.

The embodiments of the present disclosure do not limit the shapes of main outlines of each first sub touch electrode 411 and each second sub touch electrode 421, for example, they may all be rhombus-shaped as shown in Fig. 2. In other examples, the first sub touch electrode 411 and the second sub touch electrode 421 may also be in other shapes, such as rectangles, triangles, etc.

Each first touch electrode channel 410 and each second touch electrode channel 420 are insulated from each other and intersect with each other, to form a plurality of touch units 400 at the intersection position. Each touch unit includes a portion of each of the two first touch electrodes connected at the intersection position and a portion of each of the two second touch electrodes connected at the intersection position. The right part of Fig. 2 shows an enlarged schematic diagram of a touch unit 400. As shown in Fig. 2, each touch unit 400 includes a half region of each of the two adjacent first sub touch electrodes 411 and a half region of each of the two adjacent second sub touch electrodes 421, that is, includes a region of one first sub touch electrode 411 and a region of one second sub touch electrode 421 on average, and the intersection point between the first sub touch electrode 411 and the second sub touch electrode 421 in each touch unit 400 (i.e. the intersection of the bridge electrode and the second connection electrode) forms a reference point for calculating coordinates. When a finger touches the capacitive screen, it affects the coupling between the first touch electrode and the second touch electrode near the touch point, thereby changing the mutual capacitance between these two electrodes. The touch sensing signal changes based on the capacitance of the touch screen, and the coordinates of each touch point can be calculated based on this reference point.

For example, the plurality of touch signal lines TL are connected in one-to-one correspondence with the plurality of touch driving electrodes and configured to provide touch signals to the corresponding touch driving electrodes. For example, in the case where the first touch electrode channel 410 is the touch driving electrode Tx, the plurality of touch signal lines TL are connected in one-to-one correspondence with the plurality of first touch electrode channels 410 and configured to respectively provide touch signals to the corresponding first touch electrode channels 410. Of course, in other embodiments, in the case where the second touch electrode channel 420 is the touch driving electrode Tx, the plurality of touch signal lines TL are connected in one-to-one correspondence with the plurality of second touch electrode channels 420 and configured to provide touch signals to the corresponding second touch electrode channels 420.

For example, in the embodiments of the present disclosure, the first light-shielding structure 011/021 and the touch signal line TL may be arranged in the same layer and made of the same material; or, the second light-shielding structure 012/021 and the touch signal line TL may be arranged in the same layer and made of the same material. Of course, the specific layers where the first light-shielding structure and the second light-shielding structure are located are not limited to the above situations, as long as the light-shielding structures can meet the requirements of blocking the light leakage region.

For example, one of the two consisting of the first light-shielding structure 011/021 and the second light-shielding structure 012/021 is made of the same material and arranged in the same layer as the first sub touch electrode 411 and the second sub touch electrode 421, and the other one of the two consisting of the first light-shielding structure 011/021 and the second light-shielding structure 012/021 is made of the same material and arranged in the same layer as both of the touch signal line TL and the bridge electrode 412. For example, the touch signal line TL is also made of the same material and arranged in the same layer as the one of the two consisting of the first light-shielding structure 011/021 and the second light-shielding structure 012/021; or, the touch signal line TL may also made of the same material and arranged in the same layer as the other one of the two consisting of the first light-shielding structure 011/021 and the second light-shielding structure 012/021, as well as the bridge electrode.

Fig. 5 is a cross-sectional schematic diagram of a non-display region including a light-shielding structure of a display panel provided by an embodiment of the present disclosure. Referring to Fig. 4 and Fig. 5, the display panel 10 further includes a light-shielding layer 2, the light-shielding layer 2 is located in the non-display region 102 and at least partially surrounds the display region 101. The touch signal line TL is located on a side of the light-shielding layer 2 close to the display region 101, and the light-shielding structure 3 is located between the light-shielding layer 2 and the touch signal line TL, to block the light leakage region between the edge of the light-shielding layer 2 close to the display region 101 and the edge of the touch signal line TL away from the display region 101. For example, the light-shielding structure 3 extends beyond the edge of the light-shielding layer 2, that is, an orthographic projection of at least part of the light-shielding structure 3 on the substrate 1 overlaps with an orthographic projection of the edge of the light-shielding layer 2 close to the display region 101 on the substrate 1, to ensure that there is no light leakage region after the light-shielding layer 2 has a fitting deviation, and to achieve a better effect of preventing light leakage at the edge of the display panel. Of course, in some embodiments, the orthographic projection of the light-shielding structure 3 on the substrate 1 may not overlap with the orthographic projection of the edge of the light-shielding layer 2 close to the display region 101 on the substrate 1, which can also achieve an effect of blocking the light leakage region.

For example, the material of the light-shielding layer 2 is an opaque material, such as an opaque organic material, which may be an opaque ink, such as black ink, to achieve a more ideal light-shielding effect and be easy to produce. In other embodiments, the material of the light-shielding layer 2 may also be other types of opaque materials, including opaque inks of other colors, etc. The type of the light-shielding layer 2 is not limited to black ink. The embodiments of the present disclosure do not limit the type of the light-shielding layer 2, as long as it is opaque and can block the light leakage from the non-display region due to refraction and reflection, and prevent the light leakage from emitting out from the display side of the display panel 10 in the non-display region 102.

For example, the touch signal line TL includes a first portion extending along the first direction D1, and the arrangement direction of the touch signal line TL and the light-shielding structure 3 is the second direction D2. The first direction D1 intersects with the second direction D2, for example, the first direction D1 is perpendicular to the second direction D2. For example, the second direction D2 is the direction from the display region to the non-display region or from the non-display region to the display region. For example, referring to Fig. 4 and Fig. 5, the display panel 10 includes a main grounding line GND, which is located on a side of the touch signal line TL away from the display region 101 to prevent the touch signal line TL from being interfered by interference signals. The main grounding line GND includes a first portion GND1 extending along the first direction D1 and surrounding the display region 101, that is, the first portion GND1 of the main grounding line GND and the first portion of the touch signal line TL both extend along the first direction D1.

For example, the main grounding line GND and the touch signal line TL are arranged in the same layer as one of the two consisting of the first light-shielding structure 011/021 and the second light-shielding structure 012/022, for example, the materials of these structures arranged in the same layer are the same.

For example, in the embodiments of the present disclosure, the extension direction of the first light-shielding structure 011/021 and the second light-shielding structure 012/022 and the extension direction of the touch signal line TL are the same and substantially parallel, but are not limited to absolute parallel. For example, deviations within 5 ° from each other can be considered as the meaning of the feature "substantially parallel".

For example, a line width, in the direction from display region 101 to non-display region 102, of at least one first light-shielding structure 011/021 is equal to a line width, in the direction from display region 101 to non-display region 102, of the first portion GND1 of the main grounding line GND, and a line width, in the direction from display region 101 to non-display region 102, of at least one second light-shielding structure 012/022 is equal to a line width, in the direction from display region 101 to non-display region 102, of the first portion GND1 of the main grounding line GND. For example, the plurality of first light-shielding structures 011/021 are arranged at same intervals with the first portion GND1 of the main grounding line GND, and the plurality of second light-shielding structures 012/022 are arranged at same intervals with the first portion GND1 of the main grounding line GND. Usually, various patterns of lines and electrodes such as the touch electrode line TL, the main grounding line GND, the first light-shielding structure 011/021, and the second light-shielding structure 012/022 are formed through a patterning process including an etching step, in this way, the plurality of first light-shielding structures 011/021, the plurality of second light-shielding structures 012/022, and the first portion GND1 of the main grounding line GND can have good etching uniformity, and the shielding of the first light leakage region 103a is also more tight, thereby achieving better effect of preventing light leakage at the edge of the display panel.

For example, as shown in Fig. 1, the substrate 1 further includes a bendable portion 104 located at an edge of the non-display region 102 away from the display region 101, and an extension portion 105 connected to the bendable portion 104. The display panel 10 has a first side for display and a second side opposite to the first side, the extension portion 105 is connected to the bendable portion 104 and can be bent to the second side of the display panel 10 through the bendable portion 104. An integrated circuit board 4 is located at the extension portion 105.

For example, as shown in Fig. 1, the display panel 10 has a first edge 11, a second edge 12 intersecting with the first edge 11, a third edge 13 opposite to the first edge 11, and a fourth edge 14 opposite to the second edge 12, the extension portion 105 is arranged along the first edge 11 of the display panel 10. At least one light-shielding light extends along at least part of the first edge 11, or at least one light-shielding light extends along at least part of the first edge 11, and along at least one selected from the group consisting of the second edge 12, the third edge 13, and the fourth edge 14.

Referring to the schematic diagram of the non-display region close to the first edge 11 after removing the light-shielding structure 3 shown in Fig. 3, the area of the light leakage region of the non-display region 102 near the first edge 11 provided with the integrated circuit board 4 is relatively large, especially the area of the first light leakage region R1 between the light-shielding layer 2 and the main grounding line GND is relatively large, it is necessary to provide sufficient light-shielding structure 3 in the first leakage region R1 near the first edge 11. For example, at least one of the other edges such as the second edge 12, the third edge 13, and the fourth edge 14 may also be provided with a light-shielding structure 3. For example, the number of the light-shielding structure 3 arranged on the first edge 11 is greater than the number of the light-shielding structure 3 arranged on the other edges.

For example, referring to Figs. 3-4, the light leakage region of the non-display region 102 of the display panel 10 includes the first light leakage region R1 mentioned above. The first light leakage region R1 is located between the edge of the light-shielding layer 2 close to the display region 101 and the grounding line GND. For example, the first light leakage region R1 is located between the edge of the light-shielding layer 2 close to the display region 101 and the edge of the grounding line GND away from the display region 101. At least part of the first light-shielding structure 011 and at least part of the second light-shielding structure 012 are located on a side of the first portion GND1 of the main grounding line GND away from the display region 101, that is, in the first light leakage region R1. For example, the light-shielding structure 3 includes a first part of light-shielding structures 01 arranged in the first light leakage region R1, and the first part of light-shielding structures 01 include a first light-shielding structure 011 located in the first light-shielding layer M1 and a second light-shielding structure 012 located in the second light-shielding layer M2.

For example, materials of the first light-shielding layer M1 and the second light-shielding layer M2 are both opaque metal materials, such as at least one of copper, aluminum, chromium, manganese, and their copper alloys. Of course, the materials of the first light-shielding layer M1 and the second light-shielding layer M2 are not limited in the embodiments of the present disclosure.

For example, the light-shielding structure 3 includes a plurality of first light-shielding structures 011 and a plurality of second light-shielding structures 012. The plurality of first light-shielding structures 011 are arranged in the direction from the display region 101 to the non-display region 102, and the plurality of second light-shielding structures 012 are arranged in the direction from the display region 101 to the non-display region 102. The plurality of first light-shielding structures 011 are spaced apart from each other, and the plurality of second light-shielding structures 012 are also spaced apart from each other.

Fig. 5 shows the first part of light-shielding structures 01 arranged in the first light leakage region R1. Combining Fig. 4 and Fig. 5, for example, the plurality of first light-shielding structures 011 are located in the first light-shielding layer M1, and the second light-shielding structure 012 is located in the second light-shielding layer M2. For example, the orthographic projections of the first light-shielding structures 011 adjacent to each other in the direction from the display region 101 to the non-display region 102 overlap with the orthographic projection of the second light-shielding structure 012 on the substrate 1. From Fig. 5, it can be seen that there is an overlap between the orthographic projections of a plurality of first light-shielding structures 011 on the substrate 1 and the orthographic projections of a plurality of second light-shielding structures 012 on the substrate 1. For example, referring to Fig. 5, the orthographic projection of the second light-shielding structure 012 on the substrate 1 at least partially overlaps with the orthographic projection of the interval between a plurality of first light-shielding structures 011 on the substrate 1; or, the orthographic projection of the first light-shielding structure 011 on the substrate 1 at least partially overlaps with the orthographic projection of the interval between a plurality of second light-shielding structures 012 on the substrate 1, that is, the first light-shielding structures and the second light-shielding structures are staggered with each other to fully cover the light leakage region and achieve a more ideal effect of preventing light leakage in the non-display region.

Alternatively, in other embodiments, for example, in the first light leakage region R1, there is no overlap in the orthographic projections of the first light-shielding structure 011 and the second light-shielding structure 012 that are adjacent to each other in the direction from the display region 101 to the non-display region 102 on the substrate 1. For example, the edges, close to each other, of the orthographic projections of the first light-shielding structure 011 and the second light-shielding structure 012 that are adjacent to each other in the direction from the display region 101 to the non-display region 102 are overlapped, that is, the edges, close to each other, of the first light-shielding structure 021 and the second light-shielding structure 022 that are adjacent are connected. In this way, the technical effect of preventing light leakage and reflection in the first light leakage region R1 can also be achieved, similar to the scheme of the orthographic projections of the first light-shielding structure 011 and the second light-shielding structure 012 that are adjacent to each other in the direction from the display region 101 to the non-display region 102 on the substrate 1 being overlapped.

For example, for the first light-shielding structure 011 and the second light-shielding structure 012 located in the first light leakage region R1, the first light-shielding structure 011 and the second light-shielding structure 012 may be grounded as auxiliary grounding lines. For example, the first light-shielding structure 011 and the second light-shielding structure 012 are connected to the main grounding line GND to be grounded; or, referring to Fig. 1, the display panel 10 further includes an integrated circuit board (IC) board 4 located in the non-display region 102, and the first light-shielding structure 011 and the second light-shielding structure 012 are electrically connected to the integrated circuit board to be grounded; or, the first light-shielding structure 011 and the second light-shielding structure 012 may also be floating as first floating lines, which transmit no electrical signal. For example, in some embodiments, a part of the first light-shielding structures 011 and a part of the second light-shielding structures 012 are grounded, while the other part of the first light-shielding structures 011 and the other part of the second light-shielding structure 012 are floating.

Referring to Fig. 5, for example, the display panel 10 further includes a dam, for example, including a first dam Dam1, which is located in the non-display region 102 and at least partially surrounds the display region 101. The touch signal line TL is located on a side of the first dam Dam1 close to the display region 101 to avoid interference of lines outside the dam on the signal transmitted by the touch signal line TL. For example, the first dam Dam1 is located on a side, close to the display region 101, of the edge 20 of the light-shielding layer 2 close to the display region 101, and on a side of the first portion GND1 of the main grounding line GND away from the display region 101; the plurality of first light-shielding structures 011 and the plurality of second light-shielding structures 012 are respectively spaced apart from each other from the display region 101 to the non-display region 102; the plurality of first light-shielding structures 011 include a first part of first light-shielding structures and a second part of first light-shielding structures, and the plurality of second light-shielding structures 012 include a first part of second light-shielding structures and a second part of second light-shielding structures; the first part of first light-shielding structures and the first part of second light-shielding structures are located on a side of the first dam Dam1 close to the display region 101. The second part of first light-shielding structures 011/021 and the second part of second light-shielding structures 012/022 are located on a side of the first dam Dam1 away from the display region 101. In the display panel 10, especially in the display panel 10 with a narrow border, the distance between the display region 101 and the first dam Dam1 is very small. In the region, outside the main grounding line GND, provided with the dam, such as the first dam Dam1, the layer above the dam is not flat. On the one hand, by testing, it was found that in the absence of a light-shielding structure to block light, the light leakage and reflection phenomena in this region that is not flat are more severe than other positions; on the other hand, if the interval between the plurality of first light-shielding structures 011 and the second light-shielding structures 012 (such as the light-shielding line extending along the first direction D1) is too small, the exposure machine cannot expose enough during the process of manufacturing these light-shielding structures using lithography technology, making it difficult to achieve the patterning of the first light-shielding structure 011 and the second light-shielding structure 012. Therefore, in the first light leakage region R1, it is required that the width of the interval between adjacent first light-shielding structures 011 is relatively large, such as not less than 8µm. Similarly, the width of the interval between adjacent second light-shielding structures 012 is also the same. It is required that the width of the interval between adjacent first light-shielding structures 012 is relatively large, such as not less than 8µm. For example, in the first light leakage region R1 between the edge of the light-shielding layer 2 and the main grounding line GND, the width of the interval between adjacent first light-shielding structures 011 is in a range of 8µm ~ 20µm, and the width of the interval between adjacent second light-shielding structures 012 is in a range of 8µm ~ 20µm. For example, the line width of each first light-shielding structure 011 in the direction from display region 101 to non-display region 102 is in a range of 8µm ~ 20µm, and the line width of each second light-shielding structure 012 in the direction from display region 101 to non-display region 102 is in a range of 8µm ~ 20µm. However, even with an interval of 8µm, there is still a risk of light leakage or reflection. To completely block the light, the plurality of first light-shielding structures 011 and the plurality of second light-shielding structures 012 located in different layers are alternately arranged to completely block the first light leakage region R1, thereby avoiding the reflection phenomenon caused by light entering the layer that is not flat below the light-shielding structure, so that no light will exit from the display side of the display panel 10 from the first light leakage region R1. Therefore, in the uneven region with the dam, the light-shielding structure 3 adopts a double-layer alternating routing design, which can significantly and effectively improve the light-shielding effect, solve the more serious problems of light leakage and reflection in this uneven region, and ensure the production yield of the plurality of first light-shielding structures and the plurality of second light-shielding structures in the uneven region.

For example, an orthographic projection of at least one selected from a group consisting of the plurality of first light-shielding structures 011 and the plurality of second light-shielding structures 012 on the substrate 1 at least partially overlaps with an orthographic projection of the first dam Dam1 on the substrate 1. For example, in the embodiment shown in Fig. 5, orthographic projections of the first light-shielding structure 1a (as a representative of the first light-shielding structure), the second light-shielding structure 2a and the second light-shielding structure 2b (as representatives of the second light-shielding structure) on the substrate 1 all overlap with the orthographic projection of the first adhesive Dam1 on the substrate 1.

For example, referring to Fig. 5, in the direction perpendicular to the main surface of the substrate 1, the first light-shielding structure 011 is located between the second light-shielding structure 012 and the first dam Dam1; the first dam Dam1 has an upper surface away from the substrate 1 and a side surface intersecting with the upper surface of the first dam Dam1; in the direction perpendicular to the main surface of the substrate 1, the first light-shielding structure 1a at least overlaps with the upper surface of the first dam Dam1, and at least one second light-shielding structure 2a/2b adjacent to the first light-shielding structure 1a overlaps with the first light-shielding structure 011 and overlaps with the side surface of the first dam Dam1.

For example, referring to Fig. 5, the side surface of the first dam Dam1 includes a first side surface located on a first side of the first light-shielding structure 1a (such as the left side of the first light-shielding structure 1a in Fig. 5) and includes a second side surface located on a second side of the first light-shielding structure 1a (such as the right side of the first light-shielding structure 1a in Fig. 5), the first side and the second side of the first light-shielding structure 1a are opposite in the direction from the display region 101 to the non-display region 102. In the direction perpendicular to the main surface of the substrate 1, the second light-shielding structure 2a adjacent to the first light-shielding structure 1a at the first side of the first light-shielding structure 1a overlaps with the first light-shielding structure 1a and overlaps with the first side surface of the first dam Dam1, and the second light-shielding structure 2b adjacent to the first light-shielding structure 1a at the second side of the first light-shielding structure 1a overlaps with the first light-shielding structure 1a and overlaps with the second side surface of the first dam Dam1. Therefore, it can ensure that the uneven region close to the first dam Dam1 is completely covered, thereby ensuring the light-shielding effect for this region.

For example, referring to Fig. 5, the display panel 10 further includes a second dam Dam2, the second dam Dam2 and the first dam Dam1 are spaced apart from each other and the second dam Dam2 is located on a side of the first dam Dam1 away from the display region 101. A part of the plurality of first light-shielding structures 011 and a part of the plurality of second light-shielding structures 012 are located between the second dam Dam2 and the first dam Dam1, the other part of the plurality of first light-shielding structures 011 and the other part of the plurality of second light-shielding structures 012 overlap with the second dam Dam2 in the direction perpendicular to the main surface of the substrate 1, similar to the case where the first light-shielding structure 011 and the second light-shielding structure 012 overlap with the first dam Dam1 mentioned above, which can ensure that the uneven region near the second dam Dam2 is completely covered, thereby ensuring the light-shielding effect for this region, and ensuring that there is no light leakage or reflection in the region between the first dam Dam1 and the second dam Dam2.

Here, "part of the plurality of first light-shielding structures 011" may be at least one first light-shielding structure 011 of the plurality of first light-shielding structures 011, or may be part of one first light-shielding structure 011; similarly, "part of the plurality of second light-shielding structures 012" may be at least one second light-shielding structure 012 of the plurality of second light-shielding structures 012, or may be part of one second light-shielding structure 012.

Referring to Fig. 2, for example, the display panel 10 further includes a detection line PCD, the detection line PCD is located in the non-display region 102 and surrounds the display region 101. The first end and the second end of the detection line PCD are both electrically connected to the integrated circuit board 4 to receive detection signals. The detection line PCD includes a first portion PCD1 surrounding the display region 101 and extending along the extension direction of the first portion of the touch signal line TL (such as along the first direction D1). The first portion PCD1 of the detection line PCD is located on a side of the first portion GND1 of the main grounding line GND away from the display region 101. After inputting a detection signal to the first end of the detection line PCD through the integrated circuit board 4, the signal on the second end of the detection line PCD can be detected to determine whether the detection line PCD is intact and whether there is a circuit breaker, thereby determining whether the region passed by the detection line PCD is broken, which may lead to the risk of line breakage in that region. The light-shielding structure 3 includes a portion located on a side of the first portion PCD1 of the detection line PCD close to the display region 101; and/or, the light-shielding structure 3 includes a portion located on a side of the first portion PCD1 of the detection line PCD away from the display region 101. In both of these situations, the light leakage region between the detection line PCD and other signal lines can be shielded.

For example, the detection line PCD and the touch signal line TL are arranged in the same layer as one of the two consisting of the first light-shielding structure 011/021 and the second light-shielding structure 012/022, for example, the materials of these structures arranged in the same layer are the same.

Referring to Figs. 3-4, for example, the display panel 10 further includes a protection line Guard, which extends along the first direction D1, that is, in the same direction as the extension direction of the first portion of the touch signal line TL. For example, the protection line Guard is located between the touch signal line TL and the main grounding line GND. A waveform of an electrical signal transmitted by the protection line Guard is basically the same as a waveform of an electrical signal transmitted by the touch signal line TL. The protection line Guard includes a first portion surrounding the display region 101. The protection line Guard can prevent the signal of the touch signal line TL at the edge position from jumping.

For example, the protection line Guard and the touch signal line TL are arranged in the same layer as one of the two consisting of the first light-shielding structure 011/021 and the second light-shielding structure 012/022, for example, materials of these structures in the same layer are the same.

Referring to Fig. 3 and Fig. 4, for example, the light leakage region includes a second light leakage region R2, the second light leakage region R2 is located between the first portion Guard1 of the protection line Guard and the first portion GND1 of the main grounding line GND. For example, the light-shielding structure 3 further includes a second part of light-shielding structures 02 located in the second light leakage region R2. The second part of light-shielding structures 02 is floating and transmits no electrical signal. The second part of light-shielding structure 02 is also a second floating line located between the first portion Guard1 of the protection line Guard and the first portion GND1 of the main grounding line GND.

For example, in some embodiments, the second part of light-shielding structures 02 further includes a first conductive structure 021 and a second conductive structure 022 located in different layers. For example, the first conductive structure 021 is located in the first conductive layer M1, and the second conductive structure 022 is located in the second conductive layer M2.

For example, the light-shielding structure 3 includes the plurality of first light-shielding structures 021 and the plurality of second light-shielding structures 022 that are located in the second light leakage region R2. The plurality of first light-shielding structures 021 are arranged in the direction from the display region 101 to the non-display region 102, and the plurality of second light-shielding structures 022 are arranged in the direction from the display region 101 to the non-display region 102. There are intervals between the plurality of first light-shielding structures 021, and there are intervals between the plurality of second light-shielding structures 022.

For example, in the second light leakage region R2, orthographic projections of the first light-shielding structure 021 and the second light-shielding structure 022 that are adjacent to each other in the direction from the display region 101 to the non-display region 102 on the substrate 1 are not completely overlapped. For example, the orthographic projections of the first light-shielding structure 021 and the second light-shielding structure 022 that are adjacent to each other in the direction from the display region 101 to the non-display region 102 on the substrate 1 are partially overlapped. In this way, by arranging the first conductive structure 021 and the second conductive structure 022 in different layers in the second light leakage region R2, it is possible to allow the first conductive structure 021 and the second conductive structure 022 to be staggered with each other, which can better block the second light leakage region R2 and completely avoid the phenomenon of light leakage and light reflection in the second light leakage region R2. For example, the orthographic projection of the second light-shielding structure 022 on the substrate 1 at least partially overlaps with the orthograph projection of the interval between the plurality of first light-shielding structures 021 on the substrate 1; or, the orthographic projection of the first light-shielding structure 021 on the substrate 1 at least partially overlaps with the orthograph projection of the interval between the plurality of second light-shielding structures 022 on the substrate 1, that is, the first light-shielding structure and the second light-shielding structure are staggered with each other to fully block the light leakage region and achieve a more ideal effect of preventing light leakage in non-display region.

Alternatively, in other embodiments, for example, in the second light leakage region R2, the orthographic projections of the first light-shielding structure 021 and the second light-shielding structure 022 that are adjacent to each other in the direction from the display region 101 to the non-display region 102 on the substrate 1 does not overlap with each other. For example, the edges, close to each other, of the orthographic projections of the first light-shielding structure 021 and the second light-shielding structure 022 that are adjacent to each other in the direction from the display region 101 to the non-display region 102 are overlapped, that is, the edges, close to each other, of the first light-shielding structure 021 and the second light-shielding structure 022 that are adjacent are connected. In this way, the technical effect of preventing light leakage and reflection in the first light leakage region R1 can also be achieved, similar to the scheme of the orthographic projections of the first light-shielding structure 021 and the second light-shielding structure 022 that are adjacent to each other in the direction from the display region 101 to the non-display region 102 on the substrate 1 being overlapped.

For example, as shown in Fig. 4, in the second light leakage region R2, line widths of the plurality of first light-shielding structures 021 in the direction from the display region 101 to the non-display region 102 may not be equal, and line widths of the plurality of second light-shielding structures 022 in the direction from the display region 101 to the non-display region 102 may not be equal. Compared to the first light leakage region R1, the width of the second light leakage region R2 in the direction from the display region 101 to the non-display region 102 is much smaller, it is not required that the line widths of the plurality of first light-shielding structures and/or the plurality of second light-shielding structures located in the second light leakage region R2 be equal, to facilitate achieving the goal of completely blocking the entire second light leakage region R2 as much as possible and reduce the requirements for the manufacturing process of the first light-shielding structure and the second light-shielding structure. Of course, in other embodiments, in the second light leakage region R2, the line widths of the plurality of first light-shielding structures 021 and the line widths of the plurality of second light-shielding structures 022 may also be equal, and the present disclosure is not limit in this aspect.

For example, referring to Fig. 3 and Fig. 4, the light leakage region includes a third light leakage region R3, the third light leakage region R3 is located between the first portion Guard1 of the protection line Guard and the touch signal line TL. The light-shielding structure 3 further includes a third part of light-shielding structures 03 located in the third light leakage region R3. The third part of light-shielding structures 03 is floating and transmits no electrical signal. The third part of light-shielding structures 03 is also a third floating line located between the first portion Guard1 of the protection line Guard and the touch signal line TL.

Referring to Fig. 5, for example, the display panel 10 further includes an encapsulation layer OC, and the light-shielding layer 2 is located on a surface of the encapsulation layer OC. For example, the encapsulation layer OC may be an FMLOC layer.

Referring to Fig. 5, for example, the light-shielding layer 2 is located on an outer side of at least part of the dams away from the display region 101, such as on an outer side of the first dam Dam1 and the second dam Dam2 away from the display region 101. For example, the dams of the display panel 10 further include a third dam Dam3, which is located on an outer side of both the first dam Dam1 and the second dam Dam2 away from the display region 101. For example, as shown in Fig. 5, in the direction perpendicular to the main surface of the substrate 1, the light-shielding layer 2 overlaps with the third dam Dam3, and both the first light-shielding structure 011 and the second light-shielding structure 012 overlap with the third dam Dam3 to completely cover the third dam Dam3.

For example, in the first light leakage region R1, the plurality of first light-shielding structures 011 and the plurality of second light-shielding structures 012 are staggered as a whole to cover the entire first light leakage region R1, so that there is no interval for light to pass through in the first light leakage region R, thereby avoiding the phenomenon of light leakage in the non-display region caused by light exiting from the first light leakage region R1.

Referring to Fig. 5, for example, the display panel 10 further includes a pixel driving circuit layer (for example, including a GOA driving circuit, but being not limited to GOA) located in the non-display region 102, the pixel driving circuit layer is configured to control the operation of display pixels. For example, the pixel driving circuit layer includes a driving element for driving the pixel circuit of the display region 101 for display, the driving element includes a transistor, a capacitor, etc. The pixel circuit of the display region 101 includes a driving transistor, and the driving transistor is configured to drive a light-emitting device to emit light. For example, the pixel circuit of the display region may further include a data transistor, a compensation transistor, and the like. For example, the pixel driving circuit layer is located on a side of the dam and the light-shielding structure 3 close to the substrate 1. For example, the pixel driving circuit layer includes a plurality of signal lines, and the plurality of signal lines include signal lines located in the display region and signal lines located in the non-display region. For example, the signal lines located in the display region include a plurality of data lines, the plurality of data lines provide data signals for controlling the display grayscale of a plurality of columns of pixels in the display region 101. For example, the plurality of data lines are located in two different layers in the non-display region, and include a first data line Data1 located in a first data transmission layer and a second data line Data2 located in a second data transmission layer. Of course, the arranging method of the data lines is not limited to this situation, and the routing arrangement of the pixel driving circuit layer in the non-display region is also not limited to the situation shown in Fig. 5. For example, referring to Fig. 5, there is an overlap between orthographic projections of the plurality of signal lines located in the non-display region on the main surface of the substrate and the orthographic projection of the light-shielding structure 3 on the main surface of the substrate. For example, the signal lines located in the non-display region are located in an Fanout region of the display panel 10, and at least part of the signal lines located in the non-display region may be electrically connected to the integrated circuit board 4 to provide a display driving signal to the pixels in the display region.

For example, the signal lines located in the non-display region may include a first power line that provides a first power voltage to the pixel circuit (e.g., providing a high-level VDD) and a second power line that provides a second power voltage to the pixel circuit (e.g., providing a low-level VSS). For example, the pixel circuit includes: a data line, a light-emitting device, and a driving transistor; the light-emitting device includes a first electrode and a second electrode, and the first power line is connected to the first electrode of the light-emitting device to receive the first power voltage; a first electrode of the driving transistor is connected to the second power line VDD to receive the second power voltage, and a second electrode of the driving transistor is connected to the second electrode of the light-emitting device to receive the second power voltage.

For the above pixel circuit, please refer to a conventional pixel circuit, for example, the pixel circuit may be 3T1C, 7T1C, 5T2C, etc. Here, T represents a transistor, C represents a capacitor, and the present application does not limit the type of the pixel circuit.

For example, the signal lines located in the non-display region may further include signal lines that provide data signals and are electrically connected to the above data lines. Of course, the signal lines located in non-display region are not limited to the types listed above.

For example, referring to Fig. 5, a pixel definition layer of the display panel 10 further includes a portion PDL located in the non-display region 102, and the display panel 10 further includes a planarization Layer IDL1, for example, the light-shielding structure 3, the touch signal line TL, and the main grounding line GND are located above the planarization layer.

For example, the display panel 10 provided by the embodiments of the present disclosure may be an OLED touch display panel, such as an FMLOC panel. Of course, the display panel 10 provided by the embodiments of the present disclosure may be an OLED touch display panel or other types of touch display panels.

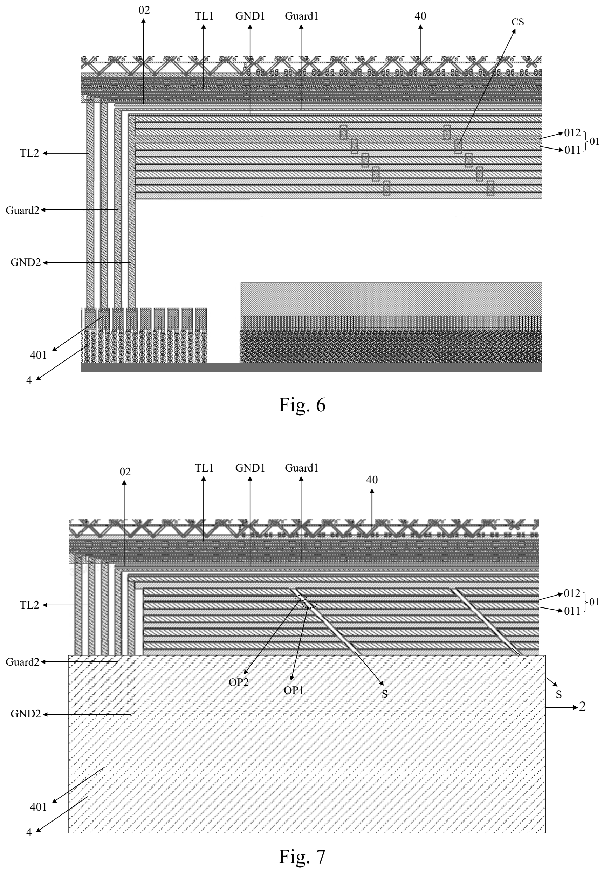

Fig. 6 is another schematic diagram of a portion, close to a first edge, of a non-display region shown in Fig. 1 including the local portion P1 of the light-shielding structure; the embodiment shown in Fig. 6 has the following differences from the embodiment shown in Figs. 4-5.

For example, as shown in Fig. 6, the main grounding line GND further includes a second portion GND2 connected to the first portion GND1, and the extension direction of the second portion GND2 of the main grounding line GND intersects with the extension direction of the first portion GND1. For example, the first portion GND1 extends along the first direction D1, at least along the first edge 11 of the display panel 10 (as shown in Fig. 1), to match the extension direction of the plurality of touch signal lines TL and make reasonable use of limited space; the second portion GND2 extends along the second direction D2 to facilitate connection with the integrated circuit board 4 below. The integrated circuit board 4 is configured to provide a driving signal for controlling the display of the display panel 10. The second portion GND2 of the main grounding line GND is connected to the integrated circuit board 4, and a grounding signal is provided to the main grounding line GND through the integrated circuit board 4.

For example, as shown in Fig. 6, the protection line Guard further includes a second portion Guard2 connected to the first portion Guard1, and the extension direction of the second portion Guard2 of the protection line Guard intersects with the extension direction of the first portion Guard1. For example, the first portion Guard1 of the protection line Guard extends along the first direction D1, and the second portion Guard2 of the protection line Guard extends along the second direction D2.

The touch signal line TL includes a first portion TL1 surrounding the display region 101, and a second portion TL2 connected to the first portion TL1 of the touch signal line TL. The extension direction of the second portion TL2 of the touch signal line TL intersects with the extension direction of the first portion TL1 of the touch signal line TL. The integrated circuit board 4 includes a plurality of integrated circuit board pins 401, and the second portion GND2 of the main grounding line GND, the second portion Guard2 of the protection line Guard, and the second portion TL2 of the touch signal line TL are respectively connected to the plurality of integrated circuit board pins 401.

Referring to Fig. 6, for example, the display panel 10 further includes a first auxiliary connection portion CS, for example, at least part of the plurality of first light-shielding structures 011 is directly connected to the second portion GND2 of the grounding line. The first auxiliary connection portion CS is arranged in the same layer as the plurality of first light-shielding structures 011, and the first auxiliary connection portion CS crosses the interval between adjacent two first light-shielding structures 011 to connect the adjacent two first light-shielding structures 011, so that the plurality of first light-shielding structures 011 have the same grounding signal, thereby ensuring the uniformity of the signals on the plurality of first light-shielding structures 011 and enhancing the stability of the touch signal transmitted by the touch electrode line TL located on the inside of the plurality of first light-shielding structures 011. Alternatively, the plurality of first light-shielding structures may also be directly connected to the second portion GND2 of the grounding line. Similarly, for the plurality of second light-shielding structures 012 located in the second light-shielding layer, a similar auxiliary connection portion may also be provided to connect adjacent two second light-shielding structures 012. For example, the display panel further includes a second auxiliary connection portion (not shown in the figure, similar to the structure of the first auxiliary connection portion CS), and at least part of the plurality of second light-shielding structures 012 is directly connected to the second portion GND2 of the grounding line GND. The difference between the second auxiliary connection portion and the first auxiliary connection portion CS is that the second auxiliary connection portion is arranged in the same layer as the plurality of second light-shielding structures 012. The second auxiliary connection portion crosses the interval between adjacent two second light-shielding structures 012 and connects the adjacent two second light-shielding structures 012 to ensure the uniformity of signals on the plurality of second light-shielding structures 012, thereby enhancing the stability of the touch signal transmitted by the touch electrode lines TL located on the inside of the plurality of second light-shielding structures 012.

The other features of the embodiment shown in Fig. 6 are the same as those in Figs. 4-5, which can be referred to in the previous descriptions of Figs. 4-5.

Fig. 7 is another schematic diagram of a portion, close to a first edge, of a non-display region shown in Fig. 1 including the local portion P1 of the light-shielding structure. The embodiment shown in Fig. 7 has the following differences from the embodiment shown in Fig. 6. Referring to Fig. 7, for example, the light-shielding structure 3 includes a plurality of first light-shielding structures 011 and a plurality of second light-shielding structures 012, each first light-shielding structure and each second light-shielding structure at least partially extend along the first direction D1. For example, in Fig. 7, the portion of each first light-shielding structure 011 extending along the first direction D1 and the portion of each second light-shielding structure 012 extending along the first direction D1 are both strip-shaped extending along the first direction D1. The second direction D2 intersects with the first direction D1, for example, the second direction D2 is perpendicular to the first direction D1, for example, the second direction D2 is the direction from the display region 101 to the non-display region 102 or from the non-display region 102 to the display region 101; the plurality of first light-shielding structures 011 are located in the first light-shielding layer M1, and the plurality of second light-shielding structures 012 are located in the second light-shielding layer M2. For example, in the first light-shielding layer M1, at least a portion, extending along the first direction D1, of at least part of the plurality of first light-shielding structure 011 is disconnected by at least one first opening OP1, and each first light-shielding structure 011 that is disconnected by the first opening OP1 includes two portions spaced apart by the first opening OP1 in the first direction D1. Similarly, in the second light-shielding layer M2, at least a portion, extending along the first direction D1, of at least part of the plurality of second light-shielding structures 012 is disconnected by at least one second opening OP2, and each second light-shielding structure 012 that is disconnected by the second opening OP2 includes two portions spaced apart by the second opening OP2 in the first direction D1. In this way, it can prevent the accumulation of excessive static electricity on the first light-shielding structure 011 and the second light-shielding structure 012 with a continuous length that is too large from interfering with the signal transmitted by the nearby touch signal line TL, which is beneficial for releasing static electricity.

For example, each first light-shielding structure 011 may be divided into a plurality of portions by a plurality of first openings OP1, the plurality of first openings OP1 are arranged in the first direction D1. For example, the two portions disconnected by one first opening OP1 respectively include a tip to facilitate the rapid release of static electricity on the first light-shielding structure 011.

Similarly, for example, each second light-shielding structure 012 may be divided into a plurality of portions by a plurality of second openings OP2, the plurality of second openings OP2 are arranged in the first direction D1. For example, the two portions disconnected by one second opening OP2 respectively include a tip to facilitate the rapid release of static electricity on the second light-shielding structure 012.

For example, orthographic projections of the plurality of first openings OP1 located in the first light-shielding layer M1 on the main surface of the substrate 1 may overlap with or not overlap with orthographic projections of the plurality of second openings OP2 located in the second light-shielding layer M2 on the main surface of the substrate 1. For example, in Fig. 7, the pattern formed by connecting the orthographic projections of the plurality of first openings OP1 and the plurality of second openings OP2 on the main surface of the substrate 1 as a whole is generally in a strip shape S extending along a third direction. The third direction intersects with both the first direction D1 and the second direction D2, which is conducive to the formation of the above tip and the regularity of the pattern, thereby reducing the manufacturing difficulty of a mask for patterning.

Of course, specific positions of the plurality of first openings OP1 and the plurality of second openings OP2 are not limited to the situation shown in Fig. 7, as long as it is possible to divide the first light-shielding structure 011 and the second light-shielding structure 012 into a plurality of portions spaced apart in the first direction D1.

The other features of the embodiment shown in Fig. 7 are the same as those in Figure 6, which can be referred to in the previous descriptions.

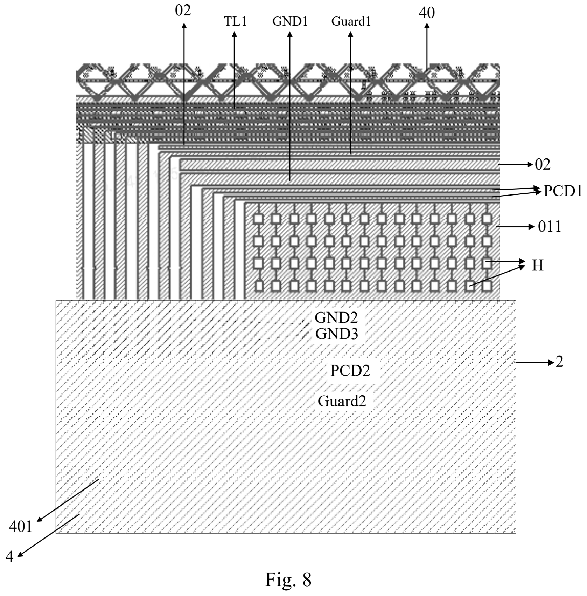

Fig. 8 is another schematic diagram of a portion, close to a first edge, of a non-display region shown in Fig. 1 including the local portion P1 of the light-shielding structure. The embodiment shown in Fig. 8 has the following differences from the embodiment shown in Fig. 4 and Fig. 5.

In Fig. 4 and Fig. 5, the first light-shielding structure and the second light-shielding structure located in the first light leakage region R1 are both line-shaped, for example, each of these lines includes a portion extending along the first direction D1. However, for example, referring to Fig. 8, in the case where the light-shielding structure 3 includes the first light-shielding structure and the second light-shielding structure located in different layers, at least one of the two consisting of the first light-shielding structure and the second light-shielding structure located on the side of the first portion GND1 of the main grounding line GND away from the display region 101 includes an integral piece of light-shielding structure. Fig. 8 Takes the case that the first light-shielding structure 011 is the integral piece of light-shielding structure as an example, a width of the integral piece of light-shielding structure in the direction from the display region 101 to the non-display region 102 is greater than half of a distance between the edge of the first portion of the touch signal line TL away from the display region 101 and the edge of the light-shielding layer 2 close to the display region 101, to make the integral piece of light-shielding structure have a larger width, which is conducive to reducing the difficulty of the manufacturing process, whether for flat regions or uneven regions with the dams, there is no need to consider the minimum spacing requirement between adjacent light-shielding structures.

For example, the width of the integral piece of light-shielding structure in the direction from the display region 101 to the non-display region 102 is greater than half of the distance between the edge of the first portion GND1 of the main grounding line GND away from the display region 101 and the edge of the light-shielding layer 2 close to the display region 101. Similarly, this can ensure that the integral piece of light-shielding structure has a large width, which is conducive to reducing the difficulty of the manufacturing process, whether for flat regions or uneven regions with dams, there is no need to consider the minimum spacing requirement between adjacent light-shielding structures.

For example, the width of the integral piece of light-shielding structure in the direction from the display region 101 to the non-display region 102 is greater than the distance between the edge of the first portion Guard1 of the protection line Guard away from the display region 101 and the edge of the first portion GND1 of the main grounding line GND close to the display region 101, this can ensure that the integral piece of light-shielding structure has a large width, which is conducive to reducing the difficulty of the manufacturing process, whether for flat regions or uneven regions with dams, there is no need to consider the minimum spacing requirement between adjacent light-shielding structures.

For example, in some embodiments, at least one of the two consisting of the first light-shielding structure and the second light-shielding structure located in the first light leakage region R1 includes the above integral piece of light-shielding structure (such as the integral piece of light-shielding structure shown in Fig. 8), and the first light-shielding structure 021 and the second light-shielding structure 022 located in the second light leakage region R2 are line-shaped (as shown in Fig. 4).

For example, orthographic projections of the edges, close to each other in the direction from the display region 101 to the non-display region 102, of the integral piece of light-shielding structure and the light-shielding layer 2 are overlapped (or just connected), or the orthographic projection of the integral piece of light-shielding structure on the main surface of the substrate 1 overlaps with the orthographic projection of the light-shielding layer 2 on the main surface of the substrate 1 to more tightly block the first light leakage region R1.

For example, the integral piece of light-shielding structure is an integral structure, and the integral piece of light-shielding structure is provided with a plurality of holes H penetrating the integral piece of light-shielding structure in the direction perpendicular to the main surface of the substrate 1 to increase the breathability of the integral piece of light-shielding structure. In the case where the material of the integral piece of light-shielding structure is a conductive material such as metal or alloy, its breathability is poor. Providing the plurality of holes H can prevent the layer, especially the organic layer, below the integral piece of light-shielding structure from the problems that the emitted water vapor and the like cannot be eliminated under heat and moisture conditions, thereby avoiding the deformation and warping of the internal layer of the display panel caused by the problems.

For example, in Fig. 8, the plurality of holes H are arranged in a regular array, which is beneficial for improving the uniformity of breathability and reducing the manufacturing difficulty. Alternatively, in other embodiments, the arrangement of the plurality of holes H may also be irregular.

For example, in Fig. 8, an area of the integral piece of light-shielding structure is greater than 0.25 mm², in this case, it is more necessary to provide the plurality of holes H to improve the breathability of the integral piece of light-shielding structure.

For example, for the integral piece of light-shielding structure, the area of the plurality of holes H in the integral piece of light-shielding structure accounts for 20% to 60% of the area of the integral piece of light-shielding structure. Through experimentation, it has been found that if the area proportion of the plurality of holes H in the integral piece of light-shielding structure is too low, ideal breathability cannot be achieved; if the area proportion of the plurality of holes H in the integral piece of light-shielding structure is too low, the ideal light-shielding effect cannot be achieved. However, the condition where the area of the plurality of holes H in the integral piece of light-shielding structure accounts for 20% to 60% of the area of the integral piece of light-shielding structure can balance breathability without affecting the light-shielding effect.

For example, in Fig. 8, the light-shielding structure 3 includes a portion located on a side of the first portion PCD1 of the detection line PCD away from the display region 101, to block a light leakage region between the first portion PCD1 of the detection line PCD and other signal lines.

For example, in Fig. 8, the integral piece of light-shielding structure may be directly connected to the pin 401 of the integrated circuit board 4 to be grounded. For example, the integral piece of light-shielding structure further includes a strip-shaped portion GND3 extending along the second direction D2, the strip-shaped portion GND3 is directly connected to the pin 401 of the integrated circuit board 4 to obtain a grounding signal from the integrated circuit board 4.

For example, an edge, away from the display region 101, of an orthographic projection the integral piece of light-shielding structure 011 on the main surface of the substrate 1 overlaps with an orthographic projection of the light-shielding layer 2 on the main surface of the substrate 1 to achieve a more rigorous light-shielding effect.

For example, the integral piece of light-shielding structure 011 is made of the same material and arranged in the same layer as the first sub touch electrode and the second sub touch electrode, or the integral piece of light-shielding structure 011 is made of the same material and arranged in the same layer as the bridge electrode.

The other features of the embodiment shown in Fig. 8 are the same as those in Fig. 7, which can be referred to in the previous descriptions.

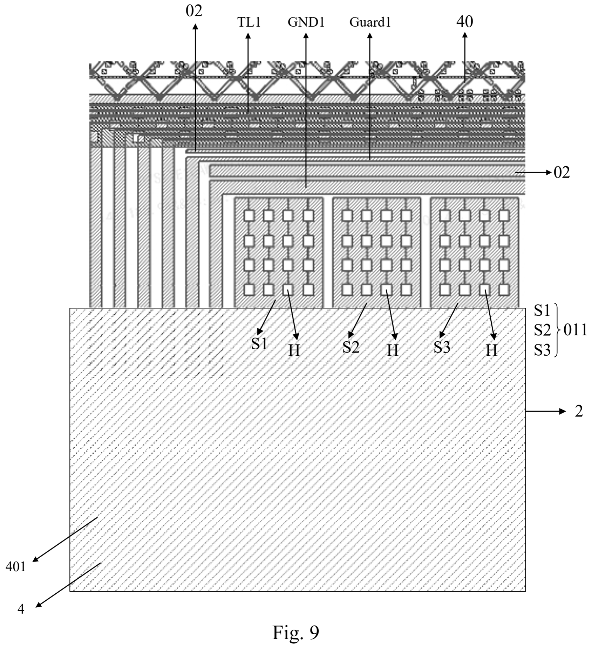

Fig. 9 is another schematic diagram of a portion, close to a first edge, of a non-display region shown in Fig. 1 including the local portion P1 of the light-shielding structure. The embodiment shown in Fig. 9 has the following differences from the embodiment shown in Fig. 8.

Referring to Fig. 9, for example, the integral piece of light-shielding structure includes a plurality of sub-portions spaced apart from each other, the plurality of sub-portions include a first sub-portion S1, a second sub-portion S2, and a third sub-portion S3. At least one sub-portion is provided with a plurality of holes H penetrating the sub-portion in the direction perpendicular to the main surface of the substrate 1. For example, each sub-portion is provided with a plurality of holes H penetrating the sub-portion in the direction perpendicular to the main surface of the substrate 1.

For example, an area of the sub-portion provided with the plurality of holes H is greater than 0.25mm², in this case, it is more necessary to provide the plurality of holes H to improve the breathability of the integral piece of light-shielding structure.

For example, for the integral piece of light-shielding structure, the area of the plurality of holes H in the integral piece of light-shielding structure accounts for 20% to 60% of the area of the integral piece of light-shielding structure. Through experimentation, it has been found that if the area proportion of the plurality of holes H in the integral piece of light-shielding structure is too low, ideal breathability cannot be achieved; if the area proportion of the plurality of holes H in the integral piece of light-shielding structure is too low, the ideal light-shielding effect cannot be achieved. However, the condition where the area of the plurality of holes H in the integral piece of light-shielding structure accounts for 20% to 60% of the area of the integral piece of light-shielding structure can balance the breathability without affecting the light-shielding effect.

The other features of the embodiment shown in Fig. 9 are the same as those in Fig. 8, which can be referred to in the previous descriptions.

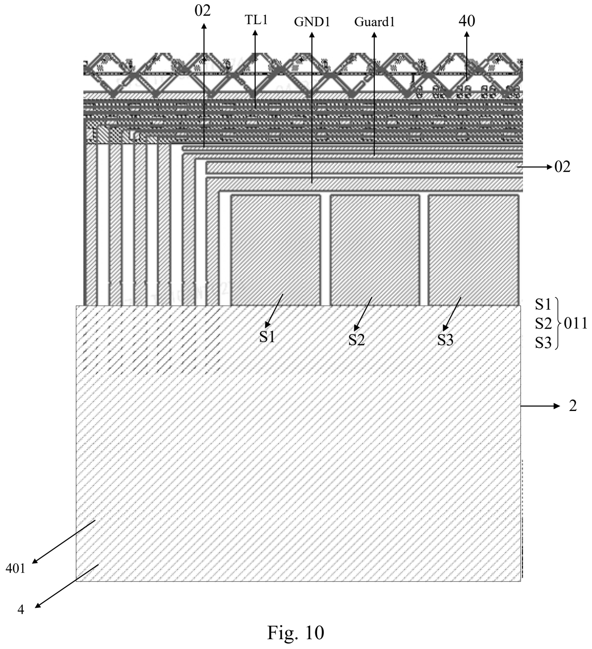

Fig. 10 is another schematic diagram of a portion, close to a first edge, of a non-display region shown in Fig. 1 including the local portion P1 of the light-shielding structure. The difference between the embodiment shown in Fig. 10 and the embodiment shown in Fig. 9 is that at least one sub-portion is provided with no hole, for example, each sub-portion is provided with no hole. All the first sub-portion S1, the second sub-portion S2, and the third sub-portion S3 are provided with no hole. For example, the area of the sub-portion provided with no hole is less than or equal to 0.25mm², the sub-portion with a smaller area may not need to be provided with a hole.

The other features of the embodiment shown in Fig. 10 are the same as those in Fig. 9, which can be referred to in the previous descriptions.

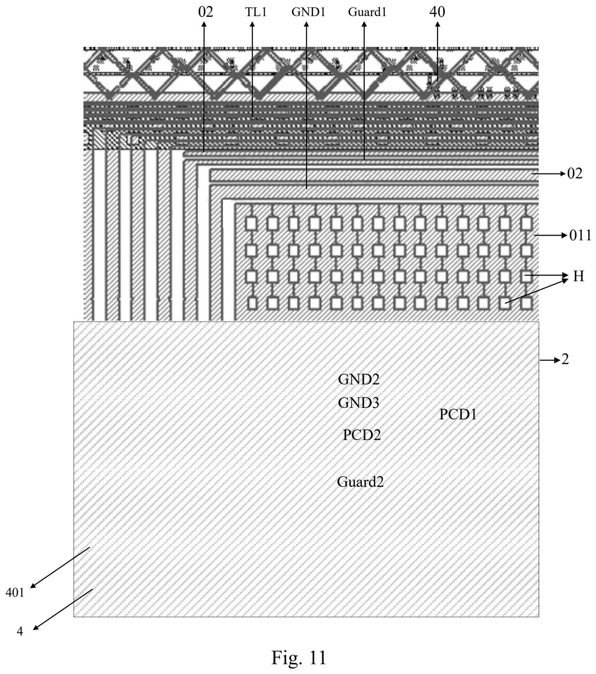

Fig. 11 is another schematic diagram of a portion, close to a first edge, of a non-display region shown in Fig. 1 including the local portion P1 of the light-shielding structure. The embodiment shown in Fig. 11 has the following differences from the embodiment shown in Fig. 8.

Referring to Fig. 11, for example, the light-shielding structure 3 includes a portion located on a side of the first portion PCD1 of the detection line PCD close to the display region 101. These two situations can also block the light leakage region between the first portion PCD1 of the detection line PCD and other signal lines.

At least one embodiment of the present disclosure further provides a display panel, referring to Fig. 8, the display panel includes a substrate 1, a touch signal line TL, a light-shielding structure 3, and a light-shielding layer 2. The substrate 1 includes a display region 101 and a non-display region 102 at least partially surrounding the display region 101. The display region 101 includes display pixels. The substrate 1 has a main surface, the display pixels, the touch signal line TL, the light-shielding structures 3, and a plurality of dams mentioned below are located on the main surface. The touch signal line TL is located in the non-display region 102 and at least partially surrounds the display region 101, and is configured to provide a touch signal to the display region 101. The touch signal line TL includes a first portion extending along the first direction D1, and the arrangement direction of the touch signal line and the light-shielding structure is the second direction D2, the first direction D1 intersects with the second direction D2. The light-shielding structure 3 is located in the non-display region 102, at least partially surrounds the display region 101, and is located on a side of the touch signal line TL away from the display region 101. The light-shielding layer 2 is located in the non-display region 102 and at least partially surrounds the display region 101. The touch signal line TL is located on a side of the light-shielding layer 2 close to the display region 101. The light-shielding structure 3 is located between the light-shielding layer 2 and the first portion of the touch signal line TL. The light-shielding structure 3 includes an integral piece of light-shielding structure 011. A width of the integral piece of light-shielding structure 011 in a direction from the display region 101 to the non-display region 102 is greater than half of a distance between an edge of the first portion of the touch signal line TL away from the display region 101 and an edge of the light-shielding layer 2 close to the display region 101, to make the integral piece of light-shielding structure have a larger width, which is conducive to reducing the difficulty of the manufacturing process, whether for flat regions or uneven regions with dams, there is no need to consider the minimum spacing requirement between adjacent light-shielding structures.

For example, the display panel 10 includes the main grounding line GND mentioned above, and the integral piece of light-shielding structure 011 is located on a side of the first portion GND1 of the main grounding line GND away from the display region 101. The integral piece of light-shielding structure 011 is grounded as an auxiliary grounding line, and the integral piece of light-shielding structure 011 is connected to the main grounding line to be grounded or electrically connected to the integrated circuit board to be grounded.

The width of the integral piece of light-shielding structure 011 in the direction from the display region 101 to the non-display region 102 is greater than half of the distance between an edge of the first portion GND1 of the main grounding line GND away from the display region 101 and the edge of the light-shielding layer 2 close to the display region 101.

For example, the display panel 10 includes the abovementioned protection line Guard, and the width of the integral piece of light-shielding structure in the direction from the display region 101 to the non-display region 102 is greater than the distance between an edge of the first portion Guard1 of the protection line Guard away from the display region 101 and an edge of the first portion GND1 of the main grounding line GND close to the display region 101.

For example, an edge, away from the display region 101, of an orthographic projection of the integral piece of light-shielding structure on the main surface of the substrate 1 overlaps with an orthographic projection of the light-shielding layer 2 on the main surface of the substrate 1, to achieve a more rigorous light-shielding effect.

In some embodiments, the light-shielding structure in the first light leakage region R1 may also be located only in the same layer, that is, in a single layer, in this case, the integral piece of light-shielding structure may also be provided. For example, the light-shielding structure 3 is made of the same material and arranged in the same layer as the touch signal line TL. The previous embodiment introduces the case where the light-shielding structure shown in Fig. 8 includes the first light-shielding structure and the second light-shielding structure located in different layers, the following introduces the features that can be satisfied in the case where the light-shielding structure is arranged in a single layer in the first light leakage region R1 shown in Fig. 8.

For example, the light-shielding structure 3 is only located in one layer, and the light-shielding structure 3 (including the integral piece of light-shielding structure 011) is made of the same material and arranged in the same layer as the first sub touch electrode and the second sub touch electrode mentioned above, or the light-shielding structure 3 (including the integral piece of light-shielding structure 011) is made of the same material and arranged in the same layer as the bridge electrode mentioned above.

For example, referring to Fig.8, orthographic projections of the edges, close to each other in the direction from the display region 101 to the non-display region 102, of the integral piece of light-shielding structure and the light-shielding layer 2 are overlapped (or just connected), or the orthographic projection of the integral piece of light-shielding structure on the main surface of the substrate 1 overlaps with the orthographic projection of the light-shielding layer 2 on the main surface of the substrate 1, to more tightly block the first light leakage region R1.

For example, the integral piece of light-shielding structure 011 is an integral structure, and the integral piece of light-shielding structure 011 is provided with a plurality of holes H penetrating the integral piece of light-shielding structure in the direction perpendicular to the main surface of the substrate 1 to increase the breathability of the integral piece of light-shielding structure. In the case where the material of the integral piece of light-shielding structure is a conductive material such as metal or alloy, its breathability is poor. Providing the plurality of holes H can prevent the layer, especially the organic layer, below the integral piece of light-shielding structure from the problems that the emitted water vapor and the like cannot be eliminated under heat and moisture conditions, thereby avoiding the deformation and warping of the internal layer of the display panel caused by the problems.

For example, in Fig. 8, the plurality of holes H are arranged in a regular array, which is beneficial for improving the uniformity of breathability and reducing the manufacturing difficulty. Alternatively, in other embodiments, the arrangement of the plurality of holes H may also be irregular.

For example, in Fig. 8, an area of the integral piece of light-shielding structure is greater than 0.25 mm², in this case, it is more necessary to provide the plurality of holes H to improve the breathability of the integral piece of light-shielding structure.

For example, for the integral piece of light-shielding structure, the area of the plurality of holes H in the integral piece of light-shielding structure accounts for 20% to 60% of the area of the integral piece of light-shielding structure. Through experimentation, it has been found that if the area proportion of the plurality of holes H in the integral piece of light-shielding structure is too low, ideal breathability cannot be achieved; if the area proportion of the plurality of holes H in the integral piece of light-shielding structure is too low, the ideal light-shielding effect cannot be achieved. However, the condition where the area of the plurality of holes H in the integral piece of light-shielding structure accounts for 20% to 60% of the area of the integral piece of light-shielding structure can balance breathability without affecting the light-shielding effect.

For example, in Fig. 8, the light-shielding structure 3 includes a portion located on a side of the first portion PCD1 of the detection line PCD away from the display region 101, to block a light leakage region between the first portion PCD1 of the detection line PCD and other signal lines.

For example, in Fig. 8, the integral piece of light-shielding structure may be directly connected to the pin 401 of the integrated circuit board 4 to be grounded. For example, the integral piece of light-shielding structure further includes a strip-shaped portion GND3 extending along the second direction D2, the strip-shaped portion GND3 is directly connected to the pin 401 of the integrated circuit board 4 to obtain a grounding signal from the integrated circuit board 4.

It should be noted that in the case where the light-shielding structure located in the first light leakage region R1 is arranged in a single layer, the display panel 10 provided by embodiments of the present disclosure may also include the various dams Dam1 to Dam3 mentioned above. Moreover, in the second light leakage region R2 and the third light leakage region R3, the light-shielding structure may be arranged in a single layer or include a first light-shielding structure and a second light-shielding structure located in different layers and overlapped with each other.

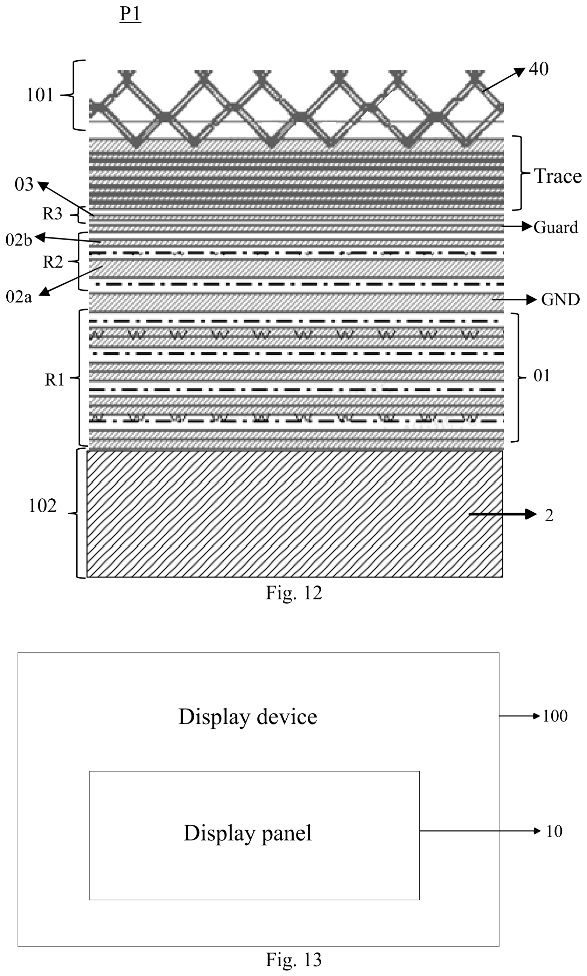

Whether for the light-shielding structure in a single layer or in multi-layers, the plurality of light-shielding structures located in the same layer are spaced apart from each other. The distance between adjacent light-shielding structures needs to be greater than or equal to 1µm to meet the requirements of the manufacturing process, avoid adjacent light-shielding structures from contacting each other and causing short circuits, and ensure the production yield of the display panel 10. For example, Fig. 12 shows that in the first light leakage region R1, the second light leakage region R2, and the third light leakage region R3, the light-shielding structure 01, the light-shielding structure 02, and the light-shielding structure 03 are all arranged in a single layer, that is, located in the same layer. The distance between adjacent light-shielding structures 01, the distance between adjacent light-shielding structures 02, and the distance between adjacent light-shielding structures 03 needs to be greater than or equal to 1µm.

Fig. 13 is a schematic diagram of a display device provided by an embodiment of the present disclosure. As shown in Fig. 13, at least one embodiment of the present disclosure further provides a display device 100, the display device 100 includes any one of the display panels 10 provided by the embodiments of the present disclosure. For example, the display device 100 may be a display panel, or any product or component with display function, such as a monitor, an OLED panel, an OLED TV, an electronic paper, a mobile phone, a tablet, laptop, a digital photo frame, a navigation device, etc.

What have been described above are only specific implementations of the present disclosure, the protection scope of the present disclosure is not limited thereto, and the protection scope of the present disclosure should be based on the protection scope of the claims.

## Claims

1. A display panel, comprising:
a substrate, comprising a display region and a non-display region at least partially surrounding the display region, wherein the display region comprises display pixels;
a touch signal line, in the non-display region, at least partially surrounding the display region, and configured to provide a touch signal to the display region; and
a light-shielding structure, in the non-display region, at least partially surrounding the display region, and on a side of the touch signal line away from the display region, wherein the light-shielding structure comprises a first light-shielding structure and a second light-shielding structure, the first light-shielding structure and the second light-shielding structure are respectively located in different layers, and orthographic projections of the first light-shielding structure and the second light-shielding structure that are adjacent to each other in a direction from the display region to the non-display region on the substrate are not completely overlapped.

2. The display panel according to claim 1, wherein the light-shielding structure comprises a plurality of first light-shielding structures, the plurality of first light-shielding structures are arranged in a direction from the display region to the non-display region, an interval is provided between the plurality of first light-shielding structures, and an orthographic projection of the second light-shielding structure on the substrate at least partially overlaps with an orthographic projection of the interval between the plurality of first light-shielding structures on the substrate.

3. The display panel according to claim 1 or 2, further comprising:
a light-shielding layer, in the non-display region and at least partially surrounding the display region, wherein the touch signal line is on a side of the light-shielding layer close to the display region, and the light-shielding structure is between the light-shielding layer and the touch signal line;
an orthographic projection of at least part of the light-shielding structure on the substrate overlaps with an orthographic projection of an edge of the light-shielding layer close to the display region on the substrate.

4. The display panel according to claim 3, wherein the touch signal line comprises a first portion extending along a first direction, an arrangement direction of the touch signal line and the light-shielding structure is a second direction, and the first direction intersects with the second direction;
the display panel further comprises:
a main grounding line, on a side of the touch signal line away from the display region, and comprising a first portion surrounding the display region and extending along the first direction;
at least part of the first light-shielding structure and at least part of the second light-shielding structure are on a side of the first portion of the main grounding line away from the display region;
the first light-shielding structure and the second light-shielding structure are grounded as auxiliary grounding lines, and the first light-shielding structure and the second light-shielding structure are connected to the main grounding line to be grounded or electrically connected to an integrated circuit board to be grounded, or,
the first light-shielding structure and the second light-shielding structure are floating to serve as first floating lines, and the first floating lines transmit no electrical signal.

5. The display panel according to claim 4, further comprising:
a first dam, in the non-display region and at least partially surrounding the display region, wherein the touch signal line is on a side of the first dam close to the display region, the first dam is on a side of the edge of the light-shielding layer close to the display region, and on a side of the first portion of the main grounding line away from the display region;
the light-shielding structure comprises a plurality of the first light-shielding structures and a plurality of the second light-shielding structures, wherein the plurality of first light-shielding structures and the plurality of second light-shielding structures are respectively spaced apart from each other from the display region to the non-display region;
the plurality of first light-shielding structures comprise a first part of first light-shielding structures and a second part of first light-shielding structures, and the plurality of second light-shielding structures comprise a first part of second light-shielding structures and a second part of second light-shielding structures; the first part of first light-shielding structures and the first part of second light-shielding structures are on a side of the first dam close to the display region, and the second part of first light-shielding structures and the second part of second light-shielding structures are on a side of the first dam away from the display region;
an orthographic projection of at least one selected from a group consisting of the plurality of first light-shielding structures and the plurality of second light-shielding structures on the substrate at least partially overlaps with an orthographic projection of the first dam on the substrate.

6. The display panel according to claim 5, wherein the substrate has a main surface, and the touch signal line, the light-shielding structure, and the first dam are on the main surface of the substrate, in a direction perpendicular to the main surface of the substrate, the first light-shielding structure is between the second light-shielding structure and the first dam;
the first dam has an upper surface away from the substrate and a side surface intersecting with the upper surface of the first dam;
in the direction perpendicular to the main surface of the substrate, the first light-shielding structure at least partially overlaps with the upper surface of the first dam, and the second light-shielding structure adjacent to the first light-shielding structure overlaps with the first light-shielding structure and overlaps with the side surface of the first dam.

7. The display panel according to claim 6, wherein the side surface of the first dam comprises a first side surface on a first side of the first light-shielding structure and a second side surface on a second side of the first light-shielding structure, the first side and the second side of the first light-shielding structure are opposite in the direction from the display region to the non-display region;
in the direction perpendicular to the main surface of the substrate, the second light-shielding structure adjacent to the first light-shielding structure on the first side of the first light-shielding structure overlaps with the first light-shielding structure and overlaps with the first side surface of the first dam, and the second light-shielding structure adjacent to the first light-shielding structure on the second side of the first light-shielding structure overlaps with the first light-shielding structure and overlaps with the second side surface of the first dam.

8. The display panel according to any one of claims 5-7, wherein the display panel further comprises a second dam, the second dam is spaced apart from the first dam and is on a side of the first dam away from the display region, a portion of the plurality of first light-shielding structures and a portion of the plurality of second light-shielding structures are between the second dam and the first dam, and another portion of the plurality of first light-shielding structures and another portion of the plurality of second light-shielding structures overlap with the second dam in the direction perpendicular to the main surface of the substrate.

9. The display panel according to any one of claims 3-8, further comprising an encapsulation layer, wherein the light-shielding layer is on an outer surface of the encapsulation layer away from the substrate;
a material of the light-shielding layer is an opaque organic material, and the opaque organic material comprises ink.

10. The display panel according to any one of claims 1-9, wherein a width, in a direction from the display region to the non-display region, of an overlapping portion of orthographic projections of the first light-shielding structure and the second light-shielding structure that are adjacent to each other in the direction from the display region to the non-display region on the substrate is greater than 1µm.

11. The display panel according to any one of claims 4-8, wherein at least one of two structures consisting of the first light-shielding structure and the second light-shielding structure on a side of the first portion of the main grounding line away from the display region comprises an integral piece of light-shielding structure, and a width of the integral piece of light-shielding structure in a direction from the display region to the non-display region is greater than half of a distance between an edge of the first portion of the main grounding line away from the display region and an edge of the light-shielding layer close to the display region.

12. The display panel according to claim 11, further comprising:
a protection line, extending along the first direction and between the touch signal line and the main grounding line, wherein a waveform of an electrical signal transmitted by the protection line is substantially same as a waveform of an electrical signal transmitted by the touch signal line, and the protection line comprises a first portion surrounding the display region;
the width of the integral piece of light-shielding structure in the direction from the display region to the non-display region is greater than a distance between an edge of the first portion of the protection line away from the display region and the edge of the first portion of the main grounding line close to the display region.

13. The display panel according to claim 11 or 12, wherein the substrate has a main surface, and the touch signal line and the light-shielding structure are on the main surface of the substrate,
the integral piece of light-shielding structure is an integral structure, and the integral piece of light-shielding structure is provided with a plurality of holes penetrating the integral piece of light-shielding structure in a direction perpendicular to the main surface of the substrate.

14. The display panel according to claim 13, wherein an area of the integral piece of light-shielding structure is greater than 0.25 mm².

15. The display panel according to claim 11 or 12, wherein the integral piece of light-shielding structure comprises a plurality of sub-portions spaced apart from each other, and at least one of the sub-portions is provided with a plurality of holes penetrating the at least one of the sub-portions in the direction perpendicular to the main surface of the substrate; or, at least one of the sub-portions is provided with no hole.

16. The display panel according to claim 15, wherein an area of the at least one of the sub-portions provided with the plurality of holes is greater than 0.25 mm², and an area of the at least one of the sub-portions provided with no hole is less than or equal to 0.25 mm².

17. The display panel according to claim 13 or 15, wherein an area of the plurality of holes in the integral piece of light-shielding structure accounts for 20% to 60% of an area of the integral piece of light-shielding structure.

18. The display panel according to any one of claims 4-17, wherein the display panel further comprises:
a detection line, in the non-display region and surrounding the display region, wherein a first end and a second end of the detection line are electrically connected to an integrated circuit board to receive a detection signal, the detection line comprises a first portion surrounding the display region and extending along the first direction, and the first portion of the detection line is on a side of the first portion of the main grounding line away from the display region;
the light-shielding structure comprises a portion on a side of the first portion of the detection line close to the display region; and/or
the light-shielding structure comprises a portion on a side of the first portion of the detection line away from the display region.

19. The display panel according to any one of claims 1-18, wherein the first light-shielding structure and the second light-shielding structure extend in a same direction as the touch signal line and are substantially parallel to the touch signal line.

20. The display panel according to any one of claims 1-19, further comprising:
a protection line, arranged along the touch signal line and between the touch signal line and the main grounding line, wherein a waveform of an electrical signal transmitted by the protection line is substantially same as a waveform of an electrical signal transmitted by the touch signal line, and the protection line comprises a first portion surrounding the display region;
the light-shielding structure further comprises:
a second floating line, between the first portion of the protection line and the first portion of the main grounding line, wherein the second floating line transmit no electrical signal.

21. The display panel according to any one of claims 1-20, wherein the touch signal line comprises a first portion extending along the first direction, an arrangement direction of the touch signal line and the light-shielding structure is a second direction, and the first direction intersects with the second direction;
the display panel further comprises:
a protection line, arranged along the touch signal line and between the touch signal line and the main grounding line, wherein a waveform of an electrical signal transmitted by the protection line is substantially same as a waveform of an electrical signal transmitted by the touch signal line, and the protection line comprises a first portion surrounding the display region and extending along the first direction;
the light-shielding structure further comprises:
a third floating line, between the first portion of the protection line and the touch signal line, wherein the third floating line transmits no electrical signal.

22. The display panel according to any one of claims 1-21, further comprising:
a first touch electrode, in the display region and comprising a plurality of first touch electrode channels spaced apart from each other, wherein the plurality of touch signal lines are connected in one-to-one correspondence with the plurality of first touch electrode channels and are configured to provide touch signals to corresponding first touch electrode channels, and each of the first touch electrode channels comprises a plurality of first sub touch electrodes spaced apart from each other;
a second touch electrode, in the display region and comprising a plurality of second touch electrode channels spaced apart from each other, wherein an extension direction of the plurality of second touch electrode channels intersects with an extension direction of the plurality of first touch electrode channels; the plurality of second touch electrode channels and the plurality of first sub touch electrodes are arranged in a same layer and are insulated from each other, each of the second touch electrode channels comprises a plurality of second sub touch electrodes spaced apart from each other; and
a bridge electrode, arranged in a different layer from the plurality of second sub touch electrodes and the plurality of first sub touch electrodes, and electrically connected to two adjacent first sub touch electrodes of the plurality of first sub touch electrodes in a same first sub touch electrode channel, and insulated from the second touch electrode,
wherein the first light-shielding structure, the first sub touch electrode and the second sub touch electrode are in a same layer and made of a same material, and the second light-shielding structure and the bridge electrode are in a same layer and made of a same material.

23. The display panel according to any one of claims 1-22, wherein the light-shielding structure comprises a plurality of the first light-shielding structures and a plurality of the second light-shielding structures, each of the first light-shielding structures and each of the second light-shielding structures at least partially extend along the first direction, the second direction intersects with the first direction; the plurality of first light-shielding structures are in a first light-shielding layer, and plurality of second light-shielding structures are in a second light-shielding layer;
in the first light-shielding layer, a portion, extending along the first direction, of at least part of the plurality of first light-shielding structures is disconnected by at least one first opening, and each first light-shielding structure of the at least part of the plurality of first light-shielding structures that is disconnected by the first opening comprises two portions spaced apart by the first opening in the first direction;
in the second light-shielding layer, a portion, extending along the first direction, of at least part of the plurality of second light-shielding structures is disconnected by at least one second opening, and each second light-shielding structure of the at least part of the plurality of second light-shielding structures that is disconnected by the second opening comprises two portions spaced apart by the second opening in the first direction.

24. The display panel according to claim 23, wherein a pattern formed by an interconnection of orthographic projections of the at least one first opening and the at least one second opening on the main surface of the substrate as a whole is in a strip shape extending along a third direction, and the third direction intersects with both the first direction and the second direction.

25. The display panel according to any one of claims 1-24, wherein the light-shielding structure comprises a plurality of the first light-shielding structures and a plurality of the second light-shielding structures, each of the first light-shielding structures and each of the second light-shielding structures at least partially extend along a first direction;
the display panel comprises a main grounding line, the main grounding line is on a side of the touch signal line away from the display region, and comprises a first portion surrounding the display region and extending along an extension direction of the touch signal line, and comprises a second portion connected to the first portion of the main grounding line, an extension direction of the second portion of the main grounding line intersects with the extension direction of the first portion of the main grounding line;
the display panel further comprises a first auxiliary connection portion, at least part of the first light-shielding structures among the plurality of first light-shielding structures is directly connected to the second portion of the grounding line, the first auxiliary connection portion and the plurality of first light-shielding structures are in a same layer, and the first auxiliary connection portion crosses an interval between two adjacent first light-shielding structures to connect the two adjacent first light-shielding structures;
the display panel further comprises a second auxiliary connection portion, at least part of the second light-shielding structures among the plurality of second light-shielding structures is directly connected to the second portion of the grounding line, the second auxiliary connection portion and the plurality of second light-shielding structures are in a same layer, and the second auxiliary connection portion crosses an interval between two adjacent second light-shielding structures to connect the two adjacent second light-shielding structures.

26. The display panel according to any one of claims 1-25, further comprising a pixel driving circuit layer in the non-display region;
the pixel driving circuit layer comprises a plurality of signal lines, the plurality of signal lines comprise a signal line in the display region and a signal line in the non-display region, an orthographic projection of the signal line in the non-display region on the main surface of the substrate overlaps with an orthographic projection of the light-shielding structure on the main surface of the substrate.

27. A display panel, comprising:
a substrate, comprising a display region and a non-display region at least partially surrounding the display region, wherein the display region comprises display pixels;
a touch signal line, in the non-display region, at least partially surrounding the display region, and configured to provide a touch signal to the display region;
a light-shielding structure, in the non-display region, and on a side of the touch signal line away from the display region, and
a light-shielding layer, in the non-display region and at least partially surrounding the display region, wherein the touch signal line is on a side of the light-shielding layer close to the display region, and the light-shielding structure is between the light-shielding layer and the touch signal line;
the touch signal line comprises a first portion extending along a first direction, an arrangement direction of the touch signal line and the light-shielding structure is a second direction, and the first direction intersects with the second direction; the light-shielding structure comprises an integral piece of light-shielding structure, a width of the integral piece of light-shielding structure in a direction from the display region to the non-display region is greater than half of a distance between an edge of the first portion of the touch signal line away from the display region and an edge of the light-shielding layer close to the display region.

28. The display panel according to claim 27, further comprising a main grounding line, wherein the main grounding line is on a side of the touch signal line away from the display region, and comprises a first portion surrounding the display region and extending along the first direction, and the integral piece of light-shielding structure is on a side of the first portion of the main grounding line away from the display region;
the integral piece of light-shielding structure is grounded as an auxiliary grounding line, and is connected to the main grounding line to be grounded or electrically connected to an integrated circuit board to be grounded.

29. The display panel according to claim 28, further comprising:
a protection line, extending along the first direction and between the touch signal line and the main grounding line, wherein a waveform of an electrical signal transmitted by the protection line is substantially same as a waveform of an electrical signal transmitted by the touch signal line, and the protection line comprises a first portion surrounding the display region;
a width of the integral piece of light-shielding structure in a direction from the display region to the non-display region is greater than a distance between an edge of the first portion of the protection line away from the display region and an edge of the first portion of the main grounding line close to the display region.

30. The display panel according to any one of claims 27-29, wherein the substrate has a main surface, and the touch signal line and the light-shielding structure are on the main surface of the substrate,
the integral piece of light-shielding structure is an integral structure, and the integral piece of light-shielding structure is provided with a plurality of holes penetrating the integral piece of light-shielding structure in a direction perpendicular to the main surface of the substrate.

31. The display panel according to any one of claims 27-30, wherein an area of the integral piece of light-shielding structure is greater than 0.25 mm².

32. The display panel according to any one of claims 27-31, wherein the substrate has a main surface, and the touch signal line and the light-shielding structure are on the main surface of the substrate;
the integral piece of light-shielding structure comprises a plurality of sub-portions spaced apart from each other, and at least one of the sub-portions is provided with a plurality of holes penetrating the at least one of the sub-portions in a direction perpendicular to the main surface of the substrate; or
at least one of the sub-portions is provided with no hole.

33. The display panel according to claim 32, wherein an area of the at least one of the sub-portions provided with the plurality of holes is greater than 0.25 mm², and an area of the at least one of the sub-portions provided with no hole is less than or equal to 0.25 mm².

34. The display panel according to claim 30 or 32, wherein an area of the plurality of holes in the integral piece of light-shielding structure accounts for 20% to 60% of an area of the integral piece of light-shielding structure.

35. The display panel according to any one of claims 27-34, wherein the substrate has a main surface, and the touch signal line and the light-shielding structure are on the main surface of the substrate, an edge, away from the display region, of an orthographic projection of the light-shielding structure on the main surface of the substrate overlaps with an orthographic projection of the light-shielding layer on the main surface of the substrate.

36. The display panel according to any one of claims 27-35, further comprising:
a first touch electrode, in the display region and comprising a plurality of first touch electrode channels spaced apart from each other, wherein the plurality of touch signal lines are connected in one-to-one correspondence with the plurality of first touch electrode channels and are configured to provide touch signals to corresponding first touch electrode channels, and each of the first touch electrode channels comprises a plurality of first sub touch electrodes spaced apart from each other;
a second touch electrode, in the display region and comprising a plurality of second touch electrode channels spaced apart from each other, wherein an extension direction of the plurality of second touch electrode channels intersects with an extension direction of the plurality of first touch electrode channels; the plurality of second touch electrode channels and the plurality of first sub touch electrodes are arranged in a same layer and are insulated from each other, each of the second touch electrode channels comprises a plurality of second sub touch electrodes spaced apart from each other; and
a bridge electrode, arranged in a different layer from the plurality of second sub touch electrodes and the plurality of first sub touch electrodes, and electrically connected to two adjacent first sub touch electrodes of the plurality of first sub touch electrodes in a same first sub touch electrode channel, and insulated from the second touch electrode,
wherein the light-shielding structure, the first sub touch electrode and the second sub touch electrode are in a same layer and made of a same material, or the light-shielding structure and the bridge electrode are in a same layer and made of a same material.

37. A display device, comprising the display panel according to any one of claims 1-36.
